# EUROPÄISCHE PATENTSCHRIFT

(11) **EP 0 907 906 B1**
(45) Veröffentlichungstag und Bekanntmachung des Hinweises auf die Patenterteilung: **17.04.2002**
(21) Anmeldenummer: 97929170.5
(22) Anmeldetag: 12.06.1997
(51) Int. Cl.: G03F 7/20

(54) **LITHOGRAPHIE-BELICHTUNGSEINRICHTUNG**
LITHOGRAPHY EXPOSURE DEVICE
DISPOSITIF D'EXPOSITION POUR LITHOGRAPHIE

(30) Priorität: 29.06.1996 DE 19626176
(43) Veröffentlichungstag der Anmeldung: 14.04.1999
(73) Patentinhaber: Deutsches Zentrum für Luft- und Raumfahrt e.V., 53111 Bonn (DE); Institut für Mikroelektronik Stuttgart (Stiftung des Öffentlichen Rechts), 70569 Stuttgart (DE)
(72) Erfinder: BRAUCH, Uwe, D-70565 Stuttgart (DE); OPOWER, Hans, D-82152 Krailling (DE); HÖFFLINGER, Bernd, D-71063 Sindelfingen (DE); SPRINGER, Reinhard, D-72172 Renfrizhausen (DE)
(74) Vertreter: Hoeger, Stellrecht & Partner
(86) Internationale Anmeldenummer: EP9703053
(87) Internationale Veröffentlichungsnummer: WO9800760

(56) Entgegenhaltungen:
- EP-A- 0 655 707
- WO-A-93/24326
- DE-A- 4 022 732
- US-A- 4 577 926
- US-A- 4 947 186
- US-A- 5 121 256
- US-A- 5 343 271
- RIEGER M L ET AL: "Image quality enhancements for raster scan lithography" OPTICAL/LASER MICROLITHOGRAPHY, SANTA CLARA, CA, USA, 2-4 MARCH 1988, Bd. 922, ISSN 0277-786X, PROCEEDINGS OF THE SPIE - THE INTERNATIONAL SOCIETY FOR OPTICAL ENGINEERING, 1988, USA, Seiten 55-64, XP000519859

## Beschreibung

Die Erfindung betrifft eine Lithographie-Belichtungseinrichtung umfassend eine Aufnahme für ein mit einer lichtempfindlichen Schicht versehenes Substrat, eine Belichtungseinheit welche eine Vielzahl von Halbleiterlasern und eine Strahlführungsoptik umfaßt, die Laserstrahlung jedes Halbleiterlasers zu einem Lichtfleck eines definierten Lichtfleckmusters führt, mit welchem die lichtempfindliche Schicht des in der Aufnahme gehaltenen Substrats belichtbar ist, eine Bewegungseinheit zur Erzeugung einer Relativbewegung zwischen der Strahlführungsoptik der Belichtungseinheit und der Aufnahme, so daß das gesamte Lichtfleckmuster und die Aufnahme in einer Belichtungsbewegungsrichtung relativ zueinander bewegbar sind und eine Steuerung zur Intensitäts- und Lagesteuerung der Lichtflecken auf der lichtempfindlichen Schicht des Substrats, mit welcher die Lichtflecken des Lichtfleckmusters entsprechend der Form der zu belichtenden Teilbereiche aktivierbar oder deaktivierbar sind, wobei das Lichtfleckmuster von einem als Referenz dienenden Lichtfleck ausgehend in einer senkrecht zur Belichtungsbewegungsrichtung verlaufenden Querrichtung in unterschiedlichen Abständen angeordnete Lichtflecken aufweist, daß jeder Lichtfleck des Lichtfleckmusters in der Querrichtung einen anderen Abstand von dem als Referenz dienenden Lichtfleck aufweist als die übrigen Lichtflecken.

Das Problem bei diesen bekannten Lithographie-Belichtungseinrichtungen besteht darin, daß die heute in der Halbleitertechnologie üblichen komplexen Schaltungsentwürfe nicht mit der erforderlichen Schnelligkeit auf die lichtempfindliche Schicht projiziert werden und daß außerdem die bekannten mit Lasern arbeitenden Lithographie-Belichtungseinrichtungen lediglich zur Herstellung von Masken, jedoch nicht direkt zur Herstellung von Strukturen direkt auf einem Halbleitersubstrat zur Erzeugung von Bauteilen eingesetzt werden können, da die herstellbaren Strukturen nicht klein genug sind. Dieser Nachteil spielt bei der Herstellung von Masken eine geringere Rolle, da die Masken Strukturen aufweisen, die ihrerseits nochmals durch eine Abbildungsoptik beim Abbilden auf die lichtempfindliche Schicht eines Wafers verkleinert werden.

Eine eingangs beschriebene Lithographie-Belichtungseinrichtung ist aus der US-A-5,343,271 bekannt. Mit dieser Lithographie-Belichtungseinrichtung ist jedoch nur die Erzeugung eines Lichtfleckmusters mit sich in der Belichtungsbewegungsrichtung erstreckenden und quer zu dieser im Abstand nebeneinanderliegenden oder bestenfalls nebenanderliegenden Lichtflecken möglich.

Aus der DE-A-4 022 732 ist eine Lithographie-Belichtungseinrichtung bekannt, bei welcher ein einziger Lichtfleck relativ zu einem Substrat gesteuert bewegt wird, um nach jeder gesteuerten Neupositionierung eines Lichtflecks einen weiteren belichteten Teilbereich zu erzeugen.

Der Erfindung liegt ausgehend von der US-A-5,343,271 die Aufgabe zugrunde, eine Lithographie-Belichtungseinrichtung zu schaffen, mit welcher mittels Lithographie mit großer Effizienz möglichst kleine Strukturen in Zeiträumen herstellbar sind, die der Größenordnung der heute üblichen, mit Masken erhältlichen Produktionszeiträume nahe kommen.

Diese Aufgabe wird bei einer Lithographie-Belichtungseinrichtung der eingangs beschriebenen Art erfindungsgemäß dadurch gelöst, daß die Abstände aller Lichtflecken des Lichtfleckmusters eine Serie von Abständen bilden, bei der jeder Abstand um ein Inkrement größer als ein anderer der Abstände ist, und daß das Inkrement kleiner als eine Erstreckung der Lichtflecken in der Querrichtung ist.

Erfindungsgemäß ist bei der Herstellung der zu belichtenden Teilbereiche ein großer Freiheitsgrad relativ zur Größe der Lichtflecken dadurch erhältlich, daß das Inkrement kleiner als eine Erstreckung der Lichtflecken in der Querrichtung ist. Das heißt, daß insgesamt in dem Lichtfleckmuster Lichtflecken in einem Abstandsraster mit dem Inkrement als Minimalabstand zur Verfügung stehen, so daß das Abstandsraster erheblich feiner ist, als die Erstreckung der Lichtflecken in der Querrichtung.

Ferner ist der Vorteil der erfindungsgemäßen Lösung darin zu sehen, daß durch die Verwendung von Halbleiterlasern die Möglichkeit geschaffen ist, in einfacher, insbesondere auch kostengünstiger Art und Weise eine Vielzahl von Lasereinheiten bereitzustellen, von denen nachher jede einen Lichtfleck des Lichtfleckmusters ergibt, das seinerseits unverändert relativ zur Aufnahme bewegbar ist. Außerdem besteht bei den Halbleiterlasern der Vorteil, daß diese einerseits eine ausreichende Ausgangsleistung zeigen und andererseits schnell, vorzugsweise im Nanosekundenbereich, aktivierbar und deaktivierbar sind.

Aufgrund der Tatsache, daß das Lichtfleckmuster in sich starr bleibt, eine Vielzahl von einzeln steuerbaren Halbleiterlasern vorgesehen sind und diese schnell ansteuerbar sind, ist es möglich, relativ große Flächen pro Zeiteinheit präzise zu belichten und somit der erfindungsgemäßen Lösung eine unter produktionstechnischen Gesichtspunkten erwünschte Durchsatzleistung zu verleihen.

Insbesondere bleibt das Lichtfleckmuster bei der Relativbewegung zwischen diesem und der Aufnahme nur dann mit der gewünschten Präzision erhalten, wenn die Strahlführungsoptik eine invariable Einheit bildet, die als Ganze während der Relativbewegung unverändert bleibt, so daß Relativbewegung zwischen dem Lichtfleckmuster und der Aufnahme nur aufgrund einer Relativbewegung zwischen der Abbildungsoptik und der Aufnahme gewährbar ist.

Damit lassen sich die zu belichtenden Teilbereiche mit ausreichend großer Geschwindigkeit und Präzision herstellen.

Dadurch, daß das Lichtfleckmuster von einem als Referenz dienenden Lichtfleck ausgehend in einer senkrecht zur Belichtungsbewegungsrichtung verlaufenden Querrichtung in unterschiedlichen Abständen angeordnete Lichtflecke aufweist, kann bei Durchführung der Relativbewegung in der Belichtungsbewegungsrichtung jeder Lichtfleck dazu eingesetzt werden, unterschiedliche Teilbereiche der lichtempfindlichen Schicht zu belichten, so daß mit einer vorgegebenen Zahl von Lichtflecken die größtmögliche Zahl von unterschiedlichen Teilbereichen der lichtempfindlichen Schicht belichtbar ist.

Erfindungsgemäß bilden die Abstände aller Lichtflecken des Lichtfleckmusters eine Serie von Abständen, bei der jeder Abstand um ein Inkrement größer ist als ein anderer der Abstände. Das heißt, daß bei der Gesamtheit der Lichtfleckmuster jeder Lichtfleck einerseits einen unterschiedlichen Abstand aufweist, andererseits sämtliche unterschiedlichen Abstände sich der Größe nach in einer Reihe anordnen lassen, wobei der Unterschied von einem Abstand zum nächsten dem Inkrement entspricht.

Besonders zweckmäßig ist es, wenn das Inkrement maximal ein Viertel der Erstreckung der Lichtflecken in der Querrichtung beträgt. Noch besser ist es, wenn das Inkrement ein Zehntel der Erstreckung der Lichtflecken in der Querrichtung beträgt, da somit mit einem Lichtfleckmuster ein Herstellen der zu belichtenden Strukturen in einem feineren Schreibraster (Grid) möglich ist.

Ein besonders vorteilhaftes Ausführungsbeispiel sieht vor, daß das Lichtfleckmuster mindestens eine in einer Reihe angeordnete Serie von Lichtflecken umfaßt, die senkrecht zur Belichtungsbewegungsrichtung einen Abstand voneinander aufweisen, welcher kleiner als deren Ausdehnung senkrecht zur Belichtungsbewegungsrichtung ist.

Hiermit besteht die Möglichkeit, eine lithographische Belichtung im Bereich innerhalb einer Erstreckung der Serie senkrecht zur Belichtungsbewegungsrichtung mit hoher Präzision durchzuführen.

Eine derartige Serie von Lichtflecken läßt sich besonders günstig herstellen, da bei Verwendung von Halbleiterlasern diese vorzugsweise in Reihen als Halbleiterlaseranordnungen eingesetzt werden, wobei zwischen den einzelnen Halbleiterlasern ein durch die Halbleiteranordnung vorgegebener Abstand besteht. Eine Abbildung einer derartigen Halbleiterlaseranordnung in das Lichtfleckmuster mit möglichst kleinen Lichtflecken führt dabei zwangsläufig zu einem derartigen Lichtfleckmuster.

Vorzugsweise ist dabei vorgesehen, daß der Abstand zwischen den Lichtflecken der Serie senkrecht zur Bewegungsrichtung konstant ist. Damit läßt sich ein besonders günstig einsetzbares Lichtfleckmuster erzielen.

Vorzugsweise bilden in diesem Fall jede in einer Reihe angeordnete Serie von Lichtflecken eine längs einer Geraden verlaufende Reihe von Lichtflecken.

Besonders günstig ist eine Lösung, bei welcher in der jeweiligen Reihe die Lichtflecken in Serienrichtung einen Abstand voneinander aufweisen, welcher größer ist als deren Erstreckung in Serienrichtung.

Um zu erreichen, daß die Lichtflecken in der senkrecht zur Belichtungsbewegungsrichtung verlaufenden Querrichtung einen möglichst kleinen Abstand voneinander aufweisen, der kleiner als die Erstreckung der Lichtflecken in der Querrichtung ist, ist vorzugsweise vorgesehen, daß die Serienrichtung einen Winkel von ungleich 90° - beispielsweise kleiner als 90° - mit der Belichtungsbewegungsrichtung einschließt. Damit bewirkt die Projektion der in der Serie angeordneten Lichtflecken auf die senkrecht zur Belichtungsbewegungsrichtung verlaufende Querrichtung eine Verringerung des Abstandes in dem vorstehend genannten Maße.

Prinzipiell können bei der erfindungsgemäßen Vorrichtung Halbleiterlaser eingesetzt werden, welche im blauen Spektralbereich oder im nahen UV Laserstrahlung erzeugen. Da derartige Halbleiterlaser bislang nicht das für einen kommerziellen Einsatz erforderliche Preis-Leistungsverhältnis aufweisen, ist vorzugsweise vorgesehen, daß die Belichtungseinheit den Halbleiterlasern nachgeschaltete Frequenzverdoppler umfaßt. In diesem Fall ist es möglich, konventionelle im roten oder infraroten Spektralbereich arbeitende Halbleiterlaser einzusetzen und die Frequenz zu verdoppeln.

Im Zusammenhang mit der bisherigen Erläuterung der einzelnen Ausführungsbeispiele wurde nicht im einzelnen darauf eingegangen, wie die Laserstrahlung von den Halbleiterlasern zu der Strahlführungsoptik geführt werden soll da die Strahlführungsoptik und die Aufnahme relativ zueinander bewegbar sein müssen. Beispielsweise wäre es denkbar - wie bereits vorstehend erwähnt - die Halbleiterlaseranordnungen oder Halbleiterlaserarrays unmittelbar zu verwenden und ausgehend von diesem System mittels der Strahlführungsoptik die einzelnen Laserstrahlen auf die lichtempfindliche Schicht zur Erzeugung des Lichtfleckmusters abzubilden, so daß die Halbleiterlaser und die Strahlführungsoptik eine Einheit bilden und dabei diese Einheit und die Aufnahme relativ zueinander bewegbar sind.

Aufgrund der mit erheblichem Aufwand verbundenen und für Halbleiterlasereinheiten erforderlichen Betriebseinrichtungen ist dies jedoch vielfach nur begrenzt möglich. Aus diesem Grund ist vorteilhafterweise vorgesehen, daß die Belichtungseinheit die Laserstrahlung zur Strahlführungsoptik leitende Lichtleiter umfaßt, welche die Möglichkeit eröffnen, von weiter entfernt angeordneten Halbleiterlasern die Laserstrahlung möglichst verlustarm zur Strahlführungsoptik zu bringen, so daß in diesem Fall die Strahlführungsoptik und die Aufnahme die relativ zueinander bewegbaren Einheiten bilden.

Vorzugsweise werden für derartige Lichtleiter Monomodefasern eingesetzt und als Halbleiterlaser solche, welche im Singlemodebetrieb arbeiten.

Die Lichtleiter sind vorzugsweise so ausgebildet, daß sie ein erstes Ende aufweisen, in welches die Laserstrahlung einkoppelbar ist, und ein zweites Ende, aus welchem die Laserstrahlung austritt, und daß auf jedes zweite Ende folgend ein kollimierendes Element angeordnet ist, welches die divergent aus jedem einzelnen zweiten Ende der Lichtleiter austretende Laserstrahlung kollimiert und daraus ein kollimiertes Strahlungsbündel formt.

Eine derartige Lösung hat den großen Vorteil, daß die Möglichkeit besteht, das kollimierte Strahlungsbündel optimal auf die lichtempfindliche Schicht abzubilden und somit einen möglichst kleinen Durchmesser des resultierenden Lichtflecks zu erhalten, wobei in diesem Fall vorzugsweise die zweiten Enden und die die kollimierende Optik umfassende Strahlführungsoptik eine Einheit bilden und diese Einheit und die Aufnahme relativ zueinander bewegbar sind.

Hinsichtlich der Ausbildung der Strahlführungsoptik wurden bislang keine näheren Angaben gemacht. So sieht ein vorteilhaftes Ausführungsbeispiel vor, daß die Strahlführungsoptik ein verkleinernd abbildendes Teleskop umfaßt. Mit einem derartigen Teleskop besteht die Möglichkeit, die technologiebedingt und hinsichtlich der zu erzeugenden Größe der Lichtflecken in großen Abständen mit den Halbleiterlasern erzeugte Laserstrahlung vorteilhafterweise so abzubilden, daß die Abstände zwischen den Lichtflecken und die Lichtflecken selbst kleiner werden.

Mit einem derartigen Teleskop lassen sich in einfacher Weise Verkleinerungen von mehr als einem Faktor 10 erreichen.

Um insbesondere direkt lithographische Schichten für die unmittelbare Herstellung eines integrierten Schaltkreises erzeugen zu können, ist vorteilhafterweise vorgesehen, daß die Strahlführungsoptik eine die Lichtflecke erzeugende Mikroskopoptik umfaßt. Eine derartige Mikroskopoptik bildet eine einfache Möglichkeit, eine möglichst starke Reduktion der Abstände zwischen den einzelnen Lichtflecken zu erhalten.

Eine Mikroskopoptik hat jedoch den Nachteil, daß die Ausdehnung der Lichtflecken empfindlich von dem Abstand der Mikroskopoptik von der zu belichtenden Schicht abhängt. Aus diesem Grund ist vorteilhafterweise vorgesehen, daß die Mikroskopoptik an einer Höhenpositioniereinrichtung angeordnet ist und von dieser während der Belichtungsbewegung in einem definierten Abstand über der lichtempfindlichen Schicht positionierbar ist. Eine derartige Höhenpositioniereinrichtung schafft somit die Möglichkeit, die Nachteile einer derartigen Mikroskopoptik zu eliminieren oder möglichst gering zu halten.

Besonders zweckmäßig ist es, wenn ein Abstand zwischen einer der lichtempfindlichen Schicht zugewandten Unterseite der Mikroskopoptik und der lichtempfindlichen Schicht durch die Höhenpositioniereinrichtung einhaltbar ist.

Bevorzugterweise ist hierbei vorgesehen, daß der Abstand in der Größenordnung eines Durchmessers des einzelnen Lichtflecks auf der lichtempfindlichen Schicht liegt.

Mit den bislang beschriebenen Mikroskopoptiken besteht die Möglichkeit, beugungsbegrenzt Lichtflecken zu erhalten, deren Ausdehnung in der Größenordnung der Wellenlänge der Laserstrahlung liegt.

Um jedoch eine möglichst definierte Größe der einzelnen Lichtflecke, insbesondere im Bereich der Wellenlänge des eingesetzten Laserlichts oder kleiner, zu erhalten, ist vorzugsweise vorgesehen, daß die Mikroskopoptik mit einer die Größe der Lichtflecken auf der lichtempfindlichen Schicht definierenden Nahfeldoptik versehen ist.

Eine derartige Nahfeldoptik hat den großen Vorteil, daß sie aufgrund ihrer Nähe zu den auf der lichtempfindlichen Schicht erzeugten Lichtflecken die Möglichkeit eröffnet, weitgehend von der vorhergehenden Strahlführung unabhängig die endgültige Größe der Lichtflecken auf der lichtempfindlichen Schicht festzulegen.

Vorzugsweise ist dabei die Nahfeldoptik unmittelbar auf einer der lichtempfindlichen Schicht zugewandten Unterseite des Mikroskopobjektivs angeordnet, so daß der Abstand zwischen der Nahfeldoptik und der lichtempfindlichen Schicht sehr gering gehalten werden kann.

Die Nahfeldoptik kann dabei in unterschiedlichster Art und Weise ausgeführt sein.

So sieht Ausführungsbeispiel vor, daß die Nahfeldoptik die Lichtflecken des Lichtfleckmusters durch blendenähnliche Durchlaßbereiche definiert. In diesem Fall sind vorzugsweise blendenähnliche Durchlaßbereiche durch Bedampfen der Mikroskopoptik auf ihrer der lichtempfindlichen Schicht zugewandten Seite erreichbar.

Eine andere Lösung sieht vor, daß die Nahfeldoptik die Größe der Lichtflecken des Lichtfleckmusters durch strahlkonzentrierende Elemente definiert. In diesem Fall sind beispielsweise auf der der lichtempfindlichen Schicht zugewandten Seite des Mikroskopobjektivs zusätzliche strahlkonzentrierende Elemente vorgesehen, wobei diese strahlkonzentrierenden Elemente im einfachsten Fall konisch ausgebildet sind, um die auf der lichtempfindlichen Schicht erzeugten Lichtflecken bei möglichst geringer Größe zu erhalten.

Die erfindungsgemäße Nahfeldoptik ist insbesondere dann vorteilhaft einsetzbar, wenn diese die Größe der Lichtflecken in zumindest einer Richtung auf Werte deutlich unter der Wellenlänge der Laserstrahlung reduziert.

In diesem Fall ist zweckmäßigerweise der Vektor des elektrischen Feldes E der Laserstrahlung so gelegt, daß dieser parallel zu der Richtung liegt, zu welcher die Ausdehnung der Lichtflecken kleiner als die Wellenlänge ist.

Da die flächenhafte Ausdehnung der Lichtfleckmuster nicht beliebig vergrößert werden kann, ohne daß die Strahlführungsoptik aufwendig ausgeführt werden muß, ist vorteilhafterweise zur Verkürzung der erforderlichen Belichtungszeiten vorgesehen, daß die Lithographie-Belichtungseinrichtung mehrere Lichtfleckmuster erzeugt.

Jedes Lichtfleckmuster weist dabei in einem definierten geometrischen Muster angeordnete Lichtflecken auf, wobei die mehreren Lichtfleckmuster beliebig zueinander angeordnet werden können.

Prinzipiell ist es denkbar, daß die mehreren Lichtfleckmuster in unterschiedlichen Belichtungsbewegungsrichtungen bewegbar sind.

Zur Vermeidung von Überkreuzbewegungen ist es vorteilhaft, wenn die mehreren Lichtfleckmuster parallel zu einer einzigen Belichtungsbewegungsrichtung bewegbar sind.

Die mehreren Lichtfleckmuster sind vorzugsweise während desselben Belichtungsvorgangs einsetzbar, so daß während eines Belichtungsvorgangs größere Teilbereiche der lichtempfindlichen Schicht belichtbar sind.

Prinzipiell wäre es möglich, die mehreren Lichtfleckmuster zeitversetzt zu erzeugen. Günstiger ist es jedoch, die mehreren Lichtfleckmuster im wesentlich zeitgleich zu generieren.

Insbesondere bei im wesentlichen zeitgleich generierten Lichtfleckmusten ist es von Vorteil, wenn für jedes Lichtfleckmuster eine eigene Mikroskopoptik vorgesehen ist.

Noch besser ist es, wenn für jedes Lichtfleckmuster eine eigene Strahlführungsoptik vorgesehen ist.

Die mehreren Lichtfleckmuster könnten prinzipiell aus einem Satz von Halbleiterlasern gespeist werden, insbesondere wenn mit jedem Lichtfleckmuster dieselben belichteten Teilbereiche erzeugt werden sollen.

Die Einsatzmöglichkeiten einer erfindungsgemäßen Lithographie-Belichtungseinrichtung sind jedoch größer, wenn für jedes Lichtfleckmuster ein eigener Satz von Halbleiterlasern zur Verfügung steht, so daß mit den Lichtfleckmustern unterschiedliche belichtete Teilbereiche erzeugbar sind.

Eine besonders einfach auszuführende Lösung sieht zur Erzeugung der mehreren Lichtfleckmuster mehrere Belichtungseinheiten vor, die selbständig arbeiten.

Die erfindungsgemäße Lithographie-Belichungseinrichtung ermöglicht ein lithographisches Verfahren zur Herstellung von ebenen Strukturen auf einem Substrat durch folgende Schritte : einen Beschichtungsschritt, bei welchem die lichtempfindliche Schicht auf das Substrat aufgetragen wird, einen Belichtungsschritt, bei welchem entsprechend der herzustellenden Struktur durch Lage- und Intensitätssteuerung eines mit Laserstrahlung auf der lichtempfindlichen Schicht erzeugten Lichtflecks belichtete und unbelichtete Teilbereiche der lichtempfindlichen Schicht erzeugt werden, und einen Ablöseschritt, bei welchem einer der Teilbereiche von dem Substrat abgetragen wird, wobei beim Belichtungsschritt zur Erzeugung der Laserstrahlung eine Vielzahl von Halbleiterlasern verwendet wird, mit der aus jedem Halbleiterlaser austretenden Laserstrahlung ein Lichtfleck eines definierten Lichtfleckmusters auf der lichtempfindlichen Schicht erzeugt wird und das gesamte Lichtfleckmuster und das Substrat zum Herstellen der belichteten Teilbereiche in einer Belichtungsbewegungsrichtung relativ zueinander bewegt und dabei die Lichtflecke des Lichtfleckmusters entsprechend der Form der zu erzeugenden belichteten Teilbereiche definiert aktiviert oder deaktiviert werden.

Der Vorteil des Lithographie-Verfahrens besteht darin, daß mit diesem bei hoher Geschwindigkeit und bei kostenmäßig geringem Aufwand belichtete Teilbereiche mit definierten Konturen, insbesondere für Halbleiterbauelemente, vorzugsweise integrierte Schaltkreise, unmittelbar geeigneten Konturen, herstellbar sind.

Der große Vorteil dieses Verfahrens liegt dabei darin, daß einerseits aufgrund der Verwendung der Halbleiterlaser eine ausreichende Laserlichtleistung bei kurzen Schaltzeiten zur Verfügung steht, so daß der auf die Laserlichtleistung bezogene Kostenaufwand sehr gering ist.

Besonders vorteilhaft ist es dabei, wenn die Lichtflecken des Lichtfleckmusters längs parallel zur Belichtungsbewegungsrichtung verlaufender Belichtungsbahnen relativ zu der lichtempfindlichen Schicht bewegt werden, wobei dies insbesondere durch Bewegen des die lichtempfindliche Schicht tragenden Substrats erfolgt. Damit ist eine besonders zeitsparende Vorgehensweise bei der Herstellung der belichteten Teilbereiche mit hoher Geschwindigkeit und Präzision vorgegeben.

Vorzugsweise sind dabei die Lichtflecken so angesteuert, daß diese in vollflächig über den zu belichtenden Teilbereichen der lichtempfindlichen Schicht liegenden Abschnitten der Belichtungsbahnen aktiviert und in den übrigen Abschnitten der Belichtungsbahnen deaktiviert werden. Damit ist in einfacher Weise eine Möglichkeit geschaffen, durch die Relativbewegungen zwischen Lichtflecken und Substrat belichtete Teilbereiche mit beliebiger Kontur zu erzeugen.

Dabei ist es entweder möglich innerhalb der zu belichtenden Teilbereiche mit Dauerstrich-Laserstrahlung zu arbeiten. Da jedoch das schnelle Schalten der Halbleiterlaser für die Kantengenauigkeit bei quer zur Bewegungsrichtung verlaufenden Kanten der Außenkontur wichtig ist, wird vorzugsweise auch innerhalb der zu belichtenden Teilbereiche Punkt für Punkt belichtet und somit ein Lichtfleck neben den anderen gesetzt.

Um sicherzugehen, daß innerhalb der belichteten Teilbereiche die lichtempfindliche Schicht auch entsprechend der Belichtung chemisch reagiert und insbesondere die belichteten Teilbereiche innerhalb ihrer Außenkontur zusammenhängend belichtet sind und somit auch die lichtempfindliche Schicht in ausreichendem Maße chemisch durchreagiert, ist vorteilhafterweise vorgesehen, daß die belichteten Teilbereiche durch Belichtung von innerhalb der Außenkontur liegenden und sich parallel zur Belichtungsbewegungsrichtung erstreckenden Streifenbereichen der lichtempfindlichen Schicht erzeugt werden.

Vorzugsweise werden dabei die Streifenbereiche so gelegt, daß sie in einer senkrecht zur Belichtungsbewegungsrichtung verlaufenden Querrichtung überlappen, um die flächendeckende Belichtung sicherzustellen.

Besonders günstig hierbei ist es, wenn beim Belichtungsschritt das Lichtfleckmuster in der Belichtungsbewegungsrichtung relativ zum Substrat verfahren, dann in der Querrichtung zur Belichtungsbewegungsrichtung relativ zum Substrat versetzt und erneut in der Belichtungsbewegungsrichtung verfahren wird. Diese Lösung hat den großen Vorteil, daß sie eine möglichst zeitsparende und effiziente Vorgehensweise zur Herstellung der zu belichtenden Teilbereiche erlaubt.

Hierbei ist es vorteilhaft, wenn bei der Relativbewegung das Lichtfleckmuster in der Belichtungsbewegungsrichtung durchgehend ohne Bewegung quer zur Belichtungsbewegungsrichtung über das gesamte Substrat verfahren wird, so daß alle in der Belichtungsbewegungsrichtung auch hintereinanderliegenden zu belichtenden Teilbereiche durch eine durchgehende Bewegung des Lichtfleckmusters in der Belichtungsbewegungsrichtung erzeugbar sind.

Um möglichst zeitsparend zu arbeiten, ist vorzugsweise vorgesehen, daß bei der Relativbewegung das Lichtfleckmuster in der Belichtungsbewegungsrichtung mit im wesentlichen konstanter Geschwindigkeit über das gesamte Substrat verfahren wird, so daß das zeitaufwendige Verfahren und Anhalten entfallen kann.

Dabei werden die Halbleiterlaser entsprechend schnell angesteuert, wobei die Halbleiterlaser im aktivierten Zustand entweder im Pulsbetrieb oder kontinuierlich arbeiten.

Hinsichtlich des Steuerungsaufwandes und des Zeitaufwandes ist es besonders günstig, wenn die Belichtung der zu belichtenden Teilbereiche der lichtempfindlichen Schicht nur während der Relativbewegung des Lichtfleckmusters parallel zu einer einzigen Belichtungsbewegungsrichtung erfolgt.

Daß heißt, daß in diesem Fall lediglich bei Bewegung in Richtung der einzigen Belichtungsbewegungsrichtung eine Belichtung der lichtempfindlichen Schicht erfolgt, während jede Relativbewegung des Lichtfleckmusters in der Querrichtung lediglich dazu dient, das Lichtfleckmuster in der Querrichtung neu zu positionieren, mit diesem jedoch bei dem Bewegen in Querrichtung keine Belichtung durchzuführen.

Insbesondere bei der Belichtung großer lichtempfindlicher Schichten ist vorzugsweise vorgesehen, daß die Belichtung sämtlicher zu belichtenden Teilbereiche der lichtempfindlichen Schicht auf dem Substrat durch mehrfache Relativbewegung des Lichtfleckmusters in der Belichtungsbewegungsrichtung erfolgt.

Eine besonders günstige Verfahrensweise sieht dabei vor, daß das Lichtfleckmuster von einer Ausgangsstellung, in welcher die bei der Relativbewegung in Belichtungsbewegungsrichtung zuerst aktiven Lichtflecken über einem Anfang der herzustellenden belichteten Teilbereiche liegen, bis zu einer Endstellung, in welcher die zuletzt aktivierten Lichtflecken über einem Ende der herzustellenden belichteten Teilbereiche liegen, verfahren wird. Damit ist eine insbesondere zeiteffiziente Verfahrensweise vorgezeichnet.

Alle vorstehend erwähnten Relativbewegungen der Lichtflecken und des Substrats sind entweder durch Bewegung der Lichtflecken bei stehendem Substrat, Bewegung sowohl der Lichtflecken und des Substrats oder Bewegung des Substrats bei stehenden Lichtflecken realisierbar, wobei vorzugsweise mindestens die Relativbewegung in einer Richtung zumindest durch Bewegen des Substrats realisiert wird.

Besonders günstig ist die Realisierung der Relativbewegung nur durch Bewegung des Substrats, da dann die bereits bei der Maskenlithographie eingesetzten Vorrichtungen zum Bewegen des Substrats relativ zur Abbildungsoptik eingesetzt werden können.

Die erfindungsgemäße Lösung läßt sich prinzipiell bei allen Arten von lithographischen Verfahren anwenden. Anwendungsgebiete der erfindungsgemäßen Lösung sind die Herstellung von Masken für die Halbleiterfertigung mit hoher Geschwindigkeit und hoher Präzision. Noch vorteilhafter in der Halbleiterfertigung läßt sich die erfindungsgemäße Lösung jedoch dann einsetzen, wenn diese zur unmittelbaren Herstellung von belichteten Teilbereichen auf dem Halbleiterwafer mit definierter Kontur, beispielsweise den Konturen, die für hochintegrierte Bauteile erforderlich sind, eingesetzt wird.

In diesem Fall ist vorzugsweise vorgesehen, daß das Substrat ein Wafer ist und daß das Lichtfleckmuster bei jeder Relativbewegung in der Bewegungsrichtung über den gesamten Wafer hinwegbewegt wird und erst dann quer zur Belichtungsbewegungsrichtung verfahren wird.

Weitere Merkmale und Vorteile der erfindungsgemäßen Lösung sind Gegenstand der nachfolgenden Beschreibung sowie der zeichnerischen Darstellung einiger Ausführungsbeispiele.

In der Zeichnung zeigen:
- Fig. 1: eine schematische Ansicht einer erfindungsgemäßen Lithographie-Belichtungseinrichtung;
- Fig. 2: eine ausschnittsweise Darstellung eines Lichtfleckmusters auf einem die lichtempfindliche Schicht tragende Wafer;
- Fig. 3: eine ausschnittsweise Darstellung einer Aufbauvariante der erfindungsgemäßen Lösung umfassend Halbleiterlaser, deren Laserstrahlung frequenzverdoppelt wird;
- Fig. 4: eine schematische Ansicht ähnlich Fig. 1 einer Aufbauvariante der erfindungsgemäßen Lösung;
- Fig. 5: eine exemplarische Darstellung eines zu belichtenden Teilbereichs der lichtempfindlichen Schicht mit seiner Außenkontur;
- Fig. 6: eine erste Belichtungsbewegung zur Herstellung des in Fig. 5 dargestellten zu belichtenden Teilbereichs bei einer nicht der Erfindung entsprechenden Lösung;
- Fig. 7: eine zweite Belichtungsbewegung zur Herstellung des in Fig. 5 dargestellten zu belichtenden Teilbereich bei einer nicht der Erfindung entsprechenden Lösung;
- Fig. 8: eine dritte Belichtungsbewegung zur Herstellung des in Fig. 5 dargestellten zu belichtenden Teilbereichs bei einer nicht der Erfindung entsprechenden Lösung;
- Fig. 9: eine vierte Belichtungsbewegung zur Herstellung des in Fig. 5 dargestellten zu belichtenden Teilbereichs bei einer nicht der Erfindung entsprechenden Lösung;
- Fig. 10: ein erstes Ausführungsbeispiel einer erfindungsgemäßen Lithographie-Beschichtungseinrichtung mit einem Aufbau gemäß Fig. 1 oder 4 mit in einer Reihe angeordneten Lichtflecken des Lichtfleckmusters;
- Fig. 11: ein zweites Ausführungsbeispiel einer Lithographie-Beschichtungseinrichtung mit einem Aufbau gemäß Fig. 1 oder 4 mit einem besonderen Lichtfleckmuster;
- Fig. 12: ein drittes Ausführungsbeispiel einer erfindungsgemäßen Lithographie-Beschichtungseinrichtung mit einem Aufbau gemäß Fig. 1 oder 4 mit einem besonderen Lichtfleckmuster;
- Fig. 13: ein Ausführungsbeispiel einer erfindungsgemäßen Lithographie-Beschichtungseinrichtung gemäß Fig. 4 mit einer ersten Variante einer Nahfeldoptik;
- Fig. 14: eine vergrößerte Darstellung der Nahfeldoptik gemäß Fig. 13 und
- Fig. 15: eine zweite Variante der Nahfeldoptik gemäß dem Ausführungsbeispiel in Fig. 13.

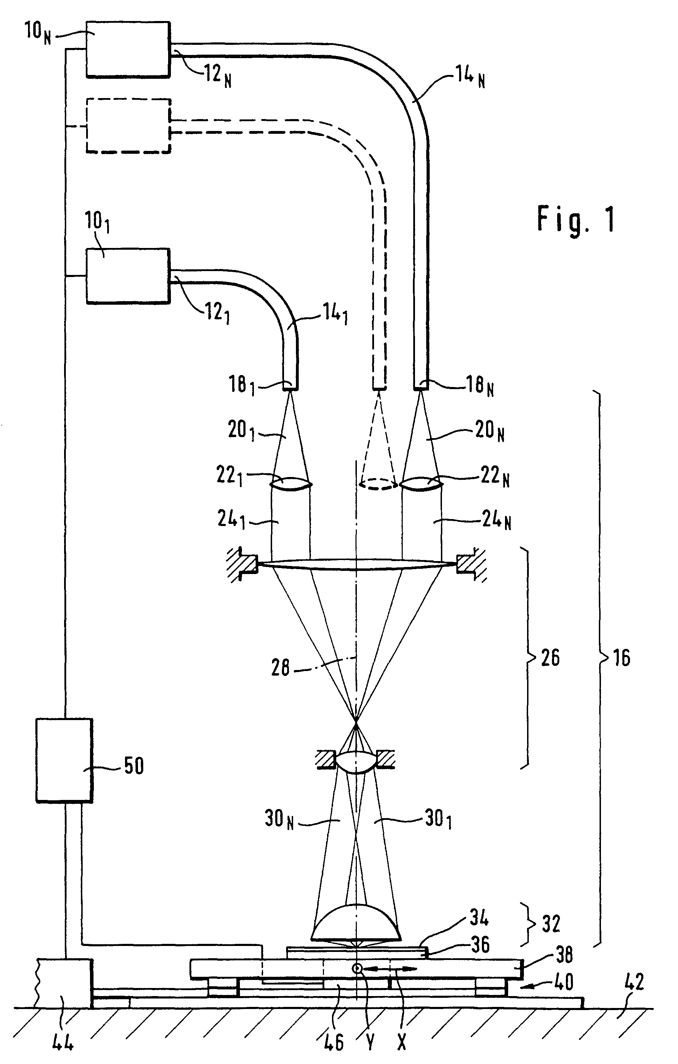

Ein erstes Ausführungsbeispiel einer erfindungsgemäßen Lithographie-Belichtungseinrichtung, dargestellt in Fig. 1, umfaßt eine Vielzahl von Lasereinheiten 10₁ bis 10_{N}, welche Halbleiterlaser umfassen und vorzugsweise Laserstrahlung im blauen Spektralbereich erzeugen, die in erste Enden 12₁ bis 12_{N} von Lichterleitern 14₁ bis 14_{N}, vorzugsweise Singlemodefasern, eintritt, von diesen zu einer als Ganzes mit 16 bezeichneten Strahlführungsoptik geführt wird und zum Eintritt in die Strahlführungsoptik 16 aus zweiten Enden 18₁ bis 18_{N} der Lichtleiter 14₁ bis 14_{N} austritt, wobei die zweiten Enden 18₁ bis 18_{N} und die Strahlführungsoptik vorzugsweise eine in sich starre optische Einheit bilden. Die Laserstrahlung tritt aus den zweiten Enden 18₁ bis 18_{N} der Lichtleiter 14₁ bis 14_{N} in Form von divergenten Strahlenbündeln 20₁ bis 20_{N} aus und wird durch jeweils kollimierende Elemente 22₁ bis 22_{N} zu jeweils kollimierten Strahlungsbündeln 24₁ bis 24_{N} geformt. Diese kollimierten Strahlungsbündel 24₁ bis 24_{N} werden durch eine von der Strahlführungsoptik 16 umfaßte Teleskopoptik 26 so abgebildet, daß deren Abstand von einer Mittelachse oder Symmetrieachse 28 verkleinert wird.

Aus der Teleskopoptik 26 treten nun wiederum divergente Strahlungsbündel 30₁ bis 30_{N} aus, die dann ihrerseits von einer Mikroskopoptik 32 auf eine lichtempfindliche Schicht 34, aufgebracht auf einem Substrat 36 abgebildet werden, wobei es zum Erhalt einer präzisen Abbildung erforderlich ist, daß die Strahlführungsoptik 16 mit deren zweiten Enden 18₁ bis 18_{N}, den kollimierenden Elementen 22₁ bis 22_{N}, der Teleskopoptik 26 sowie der Mikroskopoptik 32 eine in sich invariable optische Einheit bildet.

Das Substrat 36 ist seinerseits auf einem eine Aufnahme bildenden Verschiebetisch 38 fixiert, wobei der Verschiebetisch 38 als in zwei senkrecht zueinander verlaufende Richtungen X und Y verschieblich mittels einer Kreuzschlitteneinrichtung 40 auf einer Basis 42 fixiert ist. Zur exakten Verschiebung des Verschiebetisches 38 relativ zur Basis 42 sind zwei Stellantriebe mit Wegmeßsystemen 44 und 46 vorgesehen, welche über eine Steuerung 50 ansteuerbar sind.

Mit der Steuerung 50 sind ferner sämtliche Lasereinheiten 10₁ bis 10_{N} ebenfalls ansteuerbar.

Zur Erzeugung der Relativbewegung zwischen dem Substrat 36 und der Strahlführungsoptik 16, ist vorzugsweise die gesamte Strahlführungsoptik 16 relativ zur Basis 42 fest angeordnet, so daß einzig das Substrat 36 mit der darauf angeordneten lichtempfindlichen Schicht 34 relativ zur Strahlführungsoptik 16 beweglich ist.

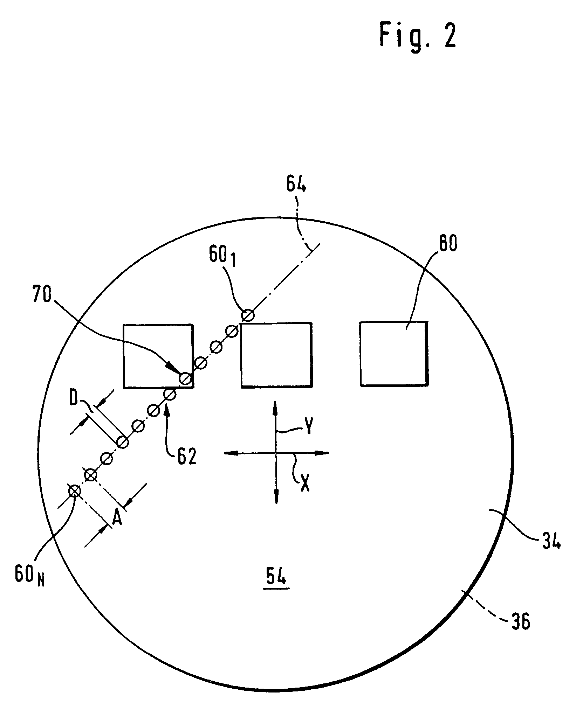

Wie in Fig. 2 dargestellt, wird die Laserstrahlung durch die Mikroskopoptik 32 beispielsweise so auf eine Oberfläche 54 der lichtempfindlichen Schicht 34 abgebildet, daß eine Vielzahl von Lichtflecken 60₁ bis 60_{N} entsteht, die jeweils denselben Durchmesser D aufweisen und in einem konstanten Abstand A voneinander als Serie 62 längs einer Serienrichtung 64 angeordnet sind und dadurch ein Lichtfleckmuster 70 auf der Oberfläche 54 bilden.

Durch die Bewegung des Substrats 36 in der X- und/oder Y-Richtung ist das gesamte Lichtfleckmuster 70 über die lichtempfindliche Schicht 34, welche das Substrat 36 bedeckt, hinwegbewegbar und zwar so, daß jeder Punkt der gesamten Oberfläche 54 durch mindestens einen Lichtfleck 60 belichtet werden kann.

Vorzugsweise ist das Substrat 36 ein Wafer üblicher Größe, auf welchem, wie in Fig. 2 angedeutet, eine Vielzahl von lithographischen Strukturen, beispielsweise für Halbleiterbauelemente 80, erzeugt werden soll.

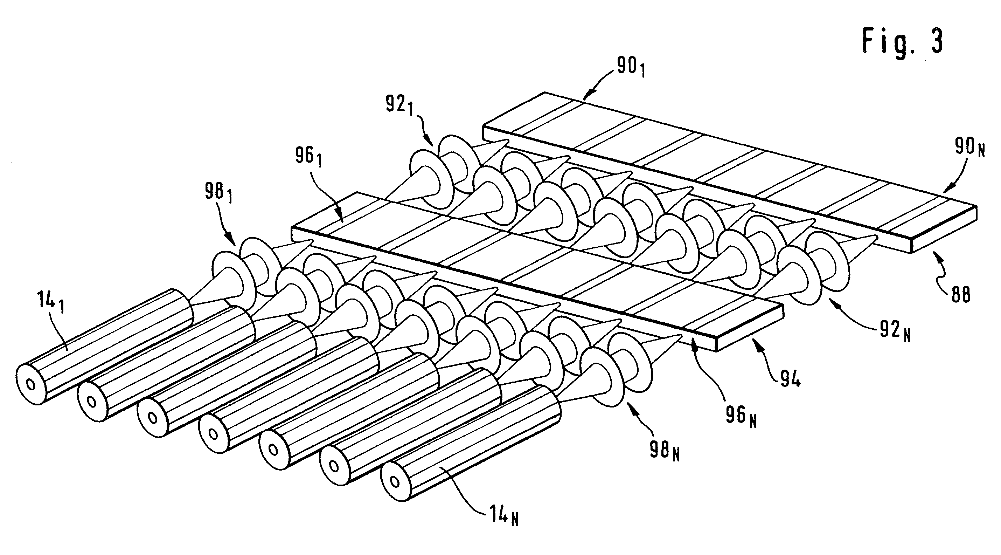

Bei einer Variante des ersten Ausführungsbeispiels sind die Lasereinheiten 10 keine Laserstrahlung im blauen Spektralbereich direkt erzeugende Lasereinheiten, sondern es ist, wie in Fig. 3 dargestellt, eine Halbleiterlaseranordnung 88 mit einer Vielzahl einzelner Halbleiterlaser 90₁ bis 90_{N} vorgesehen, welche Laserstrahlung im roten Spektralbereich emittieren und deren Laserstrahl mittels einzelner Transformationsoptiken 92₁ bis 92_{N} auf eine Verdoppleranordnung 94 mit einzelnen Verdopplersegmenten 96₁ bis 96_{N} abgebildet wird, welche die vorzugsweise im roten Spektralbereich oder nahen Infrarot emittierte Laserstrahlung der Halbleiterlaser 90₁ bis 90_{N} verdoppeln, wobei dann die aus diesen austretende Laserstrahlung mittels weiterer Transformationsoptikelemente 98₁ bis 98_{N} in die einzelnen Lichtleiter 14₁ bis 14_{N} eingekoppelt wird.

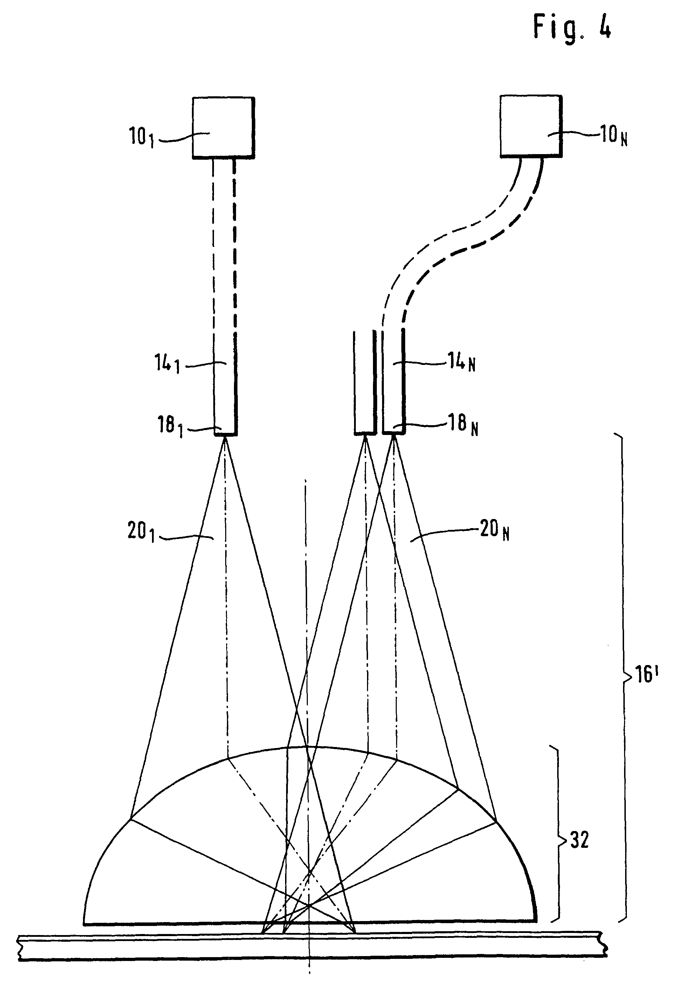

Bei einer Variante des ersten Ausführungsbeispiels einer erfindungsgemäßen Lithographie-Belichtungseinrichtung, dargestellt in Fig. 4, ist vorgesehen, daß die von den Lasereinheiten 10₁ bis 10_{N} ausgehenden Lichtleiter 14₁ bis 14_{N} zu einer Strahlführungsoptik 16' führen, welche lediglich die Mikroskopoptik 32 umfaßt. In diesem Fall sind die einzelnen Lichtleiter 14₁ bis 14_{N} nebeneinanderliegend so dicht angeordnet, daß die aus diesen austretende divergente Laserstrahlung 20₁ bis 20_{N} unmittelbar in die Mikroskopoptik 32 eintreten kann und keinerlei weiterer vorheriger Verkleinerung bedarf.

Alternativ zum Vorsehen nebeneinanderliegender Faserenden 18₁ bis 18_{N} ist es bei einer weiteren Variante denkbar, unmittelbar eine Halbleiterlaseranordnung, beispielsweise in Form von Vertikalemittern, eingangsseitig der Mikroskopoptik 32 anzuordnen.

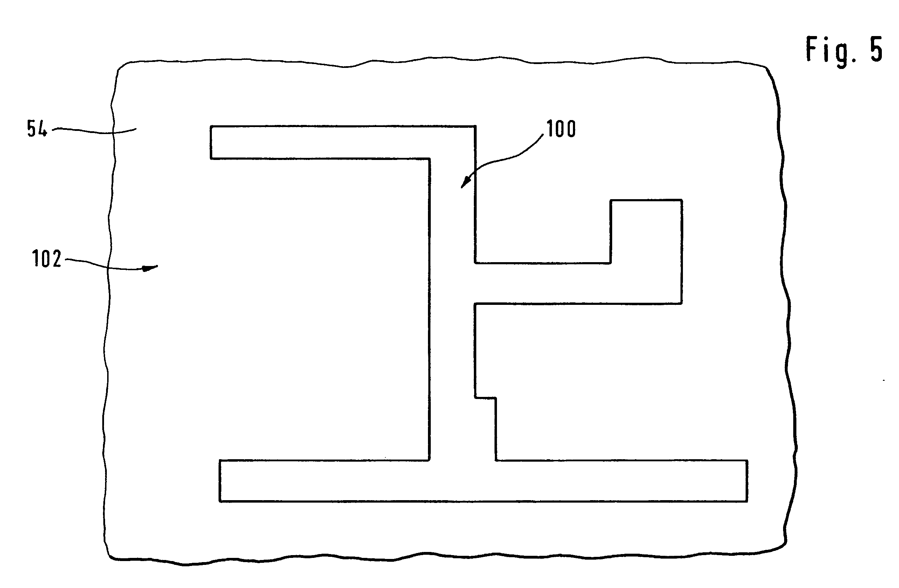

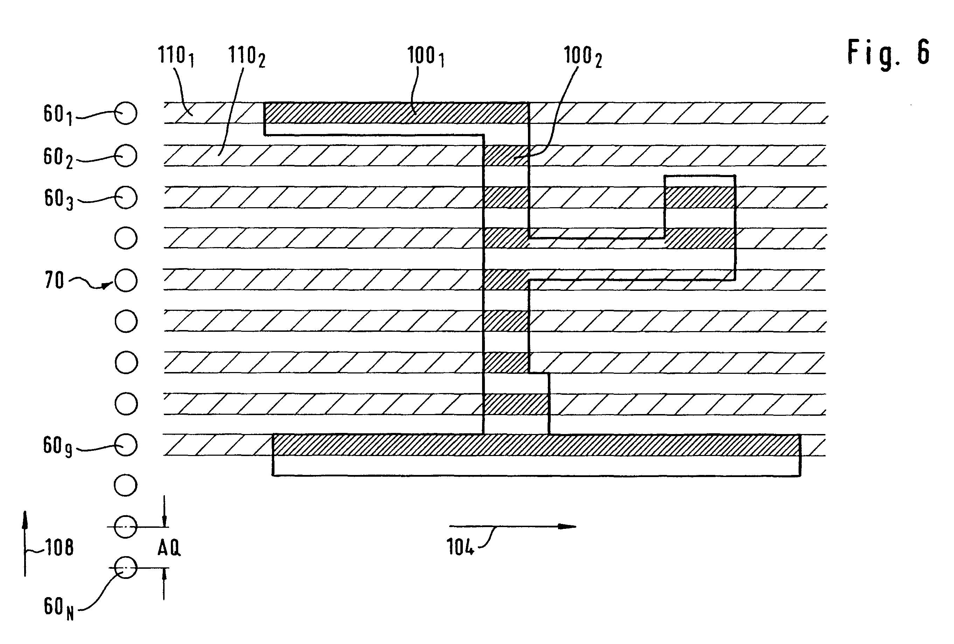

Mit der Lithographie-Belichtungseinrichtung ist es, wie in Fig. 5 dargestellt, möglich, belichtete Teilbereiche 100 und unbelichtete Teilbereiche 102 auf der Oberfläche 54 der lichtempfindlichen Schicht 34 durch Bewegen des in Fig. 6 dargestellten Lichtfleckmusters 70 mit den einzelnen Lichtflecken 60₁ bis 60_{N} beispielsweise in folgender Art und Weise herzustellen.

Das Lichtfleckmuster 70 wird so positioniert, daß bei Bewegen desselben in einer Belichtungsbewegungsrichtung 104 beispielsweise mit dem Lichtfleck 60₁ eine Belichtung im Bereich einer Belichtungsbahn 110₁ möglich ist, wobei diese Belichtungsbahn 110₁ so liegt, daß ein Streifenbereich 100₁ des zu belichtenden Teilbereichs 100 belichtbar ist, wobei der Lichtfleck 60₁ beim Bewegen längs der streifenförmigen Belichtungsbahn 110₁ erst dann aktiviert wird, wenn der Lichtfleck 60₁ in dem Abschnitt der Belichtungsbahn 110₁ steht, welcher über dem zu belichtenden Teilbereich 100 liegt, und außerhalb desselben deaktiviert wird.

In gleicher Weise ist ein Belichten mit dem Lichtfleck 60₂ im Bereich der Belichtungsbahn 110₂ zur Erzeugung eines Streifenbereichs 100₂ möglich, wobei auch der Lichtfleck 60₂ nur in den Abschnitten der Belichtungsbahn 110₂ aktiviert wird, welche vollflächig über dem zu belichtenden Teilbereich 100 liegen, um den Streifenbereich 100₂ zu erzeugen.

Gleiches gilt für die Lichtflecke 60₃ bis 60₉.

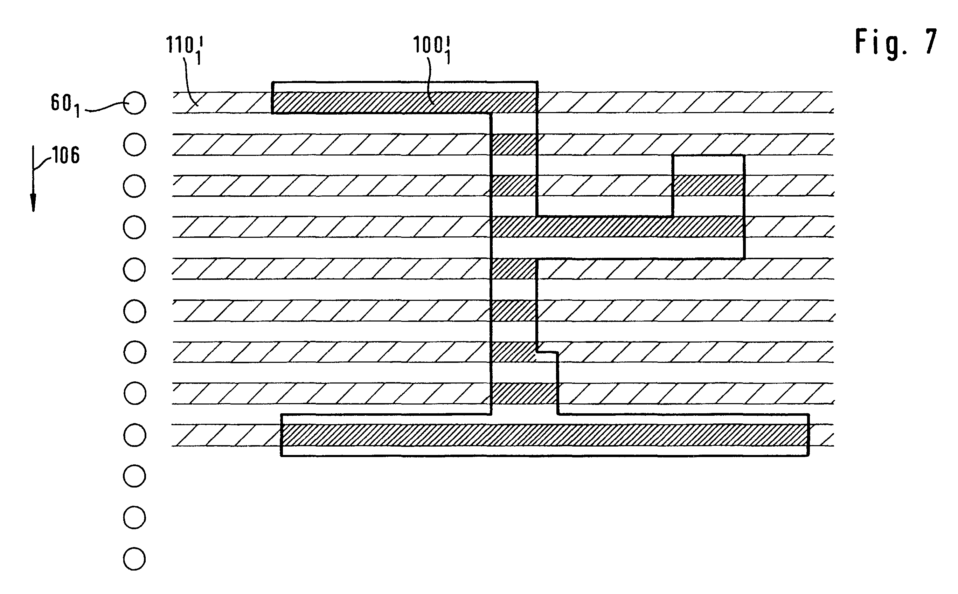

Nach einmaligem Überfahren des zu belichtenden Teilbereichs 100 erfolgt eine Querverschiebung des Lichtfleckmusters 70 in einer Querverschieberichtung 106 um eine festlegbare Strecke, die beispielsweise so gewählt wird, daß nunmehr mit der Belichtungsbahn 110₁' ein Streifenbereich 100₁' des zu belichtenden Teilbereichs 100 belichtbar ist. Dasselbe gilt für die übrigen Streifenbereiche 110₂' bis 110₉' wobei die Belichtungsbahnen 110₁ und 110₁' in Querverschieberichtung 106 überlappen sollten (Fig. 7).

Vorzugsweise liegt die Belichtungsbahn 110₁' so, daß der Streifenbereich 100₁' eine parallel zur Belichtungsbewegungsrichtung 104 verlaufende Kante des zu belichtenden Teilbereichs definiert.

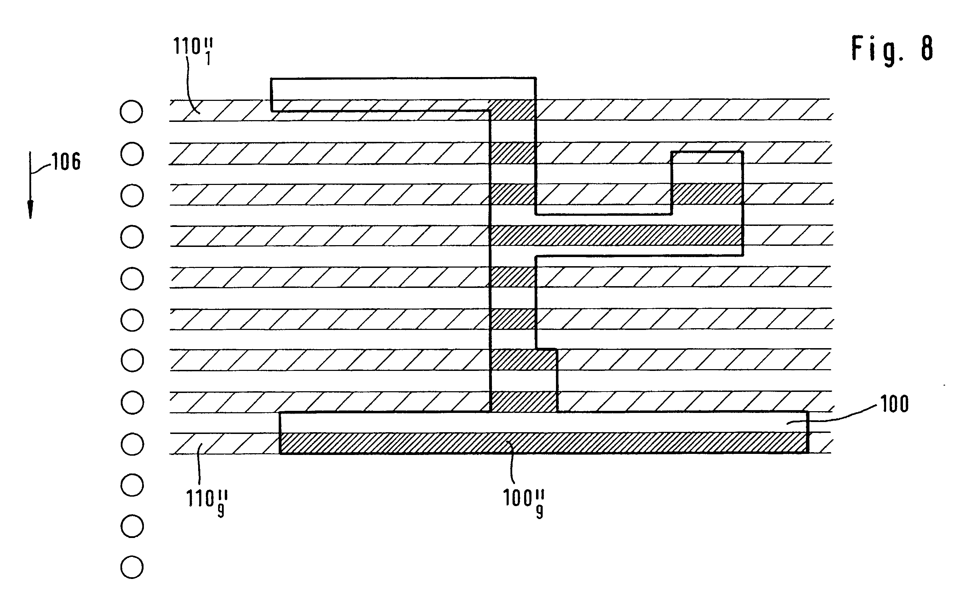

Nach Überfahren des zu belichtenden Teilbereichs 100 erfolgt eine weitere Bewegung in Querverschieberichtung 106, wie in Fig. 8 dargestellt.

Mit den weiterverschobenen Belichtungsbahnen 110" lassen sich weitere Streifenbereiche 100₁" bis 100₉" des zu belichtenden Teilbereichs 100 belichten, wobei beispielsweise mit dem Streifenbereich 100₉" eine Längskante des zu belichtenden Teilbereichs 100 erzeugbar ist.

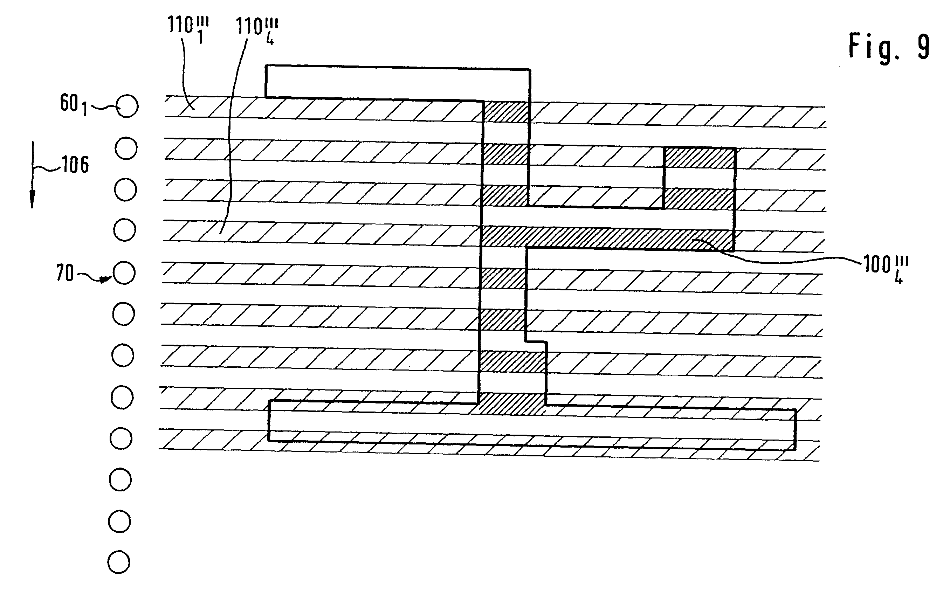

Durch eine weitere Verschiebung des Lichtfleckmusters 70 in Querrichtung 106 nach dem Überfahren des zu belichtenden Teilbereichs 100 gemäß Fig. 9 ist mit dem Belichtungsbahn 110₄" ' der Streifenbereich 100₄" ' erzeugbar, mit welchem eine weitere Längskante des zu belichtenden Teilbereichs erzeugt wird.

Im übrigen wird bei jedem Überfahren des zu belichtenden Teilbereichs 100 stets jeder der Lichtflecken 60 dann aktiviert, wenn die jeweilige Belichtungsbahn 110, 110', 110" oder 110"' voll den zu belichtenden Teilbereich 100 überdeckt, so daß in diesem Fall jeweils ein Streifenbereich des zu belichtenden Teilbereichs 100 erzeugbar ist, wobei sich alle Streifenbereiche in Richtung der Querverschieberichtung 106 überlappen, so daß letztlich nach beispielsweise viermaligem Überfahren des zu belichtenden Teilbereichs 100 parallel zur Belichtungsbewegungsrichtung 104 und jeweiligem anschließendem Verschieben in der Querverschieberichtung 106 insgesamt die Summe aller überlappenden Streifenbereiche den belichteten Teilbereich 100 ergibt.

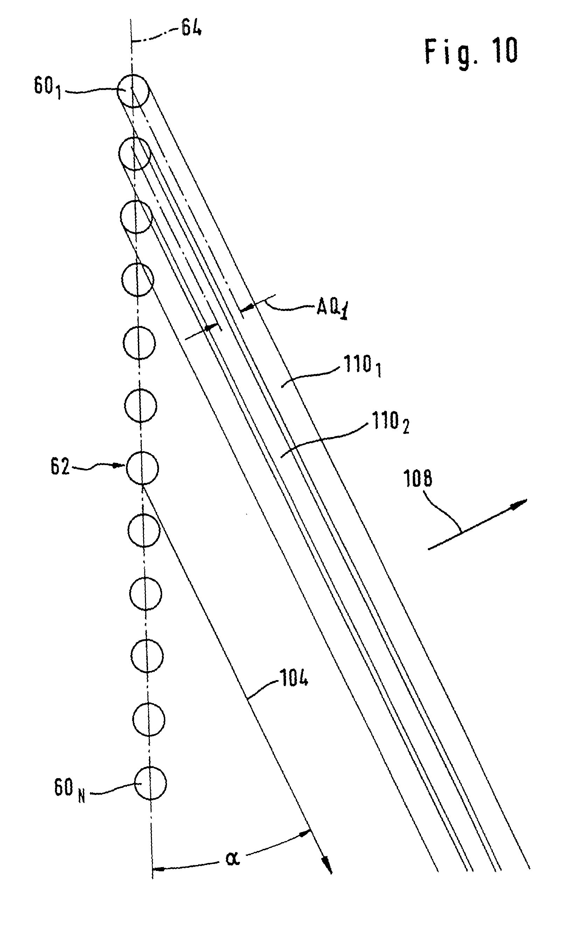

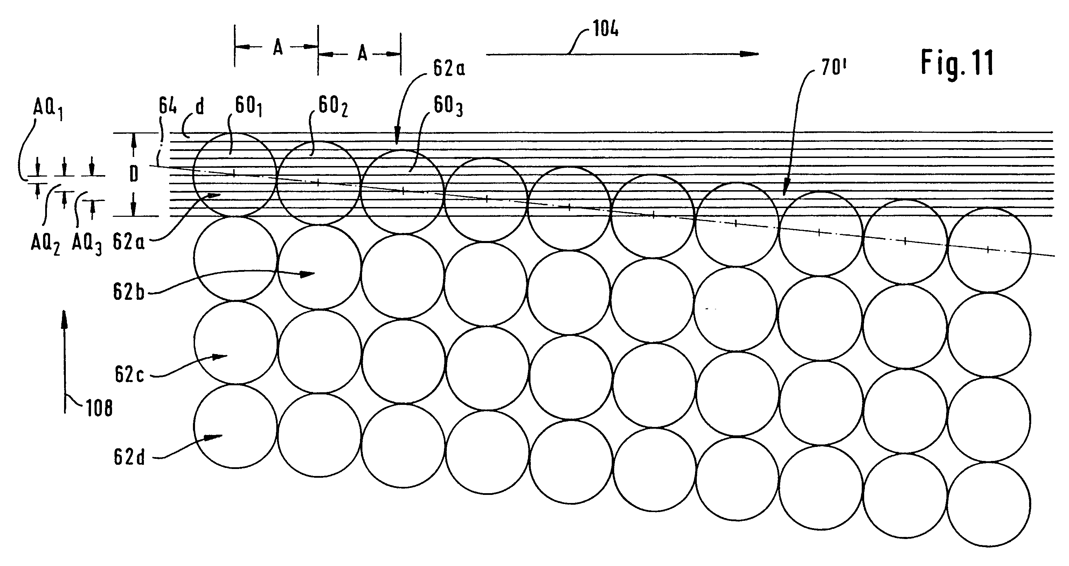

Um zur Herstellung der einander überlappenden Streifenbereiche nicht nach jedem Überfahren des zu belichtenden Teilbereichs 100 eine Querverschiebung in der Querverschieberichtung 106 durchführen zu müssen, ist bei dem ersten Ausführungsbeispiel der erfindungsgemäßen Lösung, die Serienrichtung 64 der Serie 62 der einzelnen Lichtflecken 60₁ bis 60_{N} so gelegt, daß diese in einem spitzen Winkel α zur Belichtungsbewegungsrichtung 104 verläuft, und zwar in einem derart spitzen Winkel α, daß die Belichtungsstreifen 110₁, 110₂, 110₃ etc. einander in einer Querrichtung 108 senkrecht zur Belichtungsbewegungsrichtung 104 überlappen, wie in Fig. 10 dargestellt. Ausgehend von dem Lichtfleck 60₁, welcher beispielsweise als Referenz dient, haben dann alle übrigen Lichtflecken 60₂ bis 60_{N} in der Querrichtung 108 ein Abstand AQ vom Lichtfleck 60₁, welcher für jeden Lichtflecke 60₂ bis 60_{N} anders ist, so daß sich eine Reihe von Abständen AQ₂ bis AQ_{N} ergibt, die sich immer um das Inkrement d unterscheiden, wie beim dritten Ausfühsrungsbeispiel in Fig. 11 im einzelnen dargestellt.

Damit ist es nicht mehr erforderlich, wie in den Figuren 6 bis 9 dargestellt, zur Erzeugung überlappender Belichtungsbahnen 110 nach jedem Überfahren des zu belichtenden Teilbereichs 100 eine Querverschiebung vorzunehmen, sondern es ist lediglich notwendig, einmal mit dem gesamten Lichtfleckmuster 70 den zu belichtenden Teilbereich 100 zu überfahren und stets den Lichtfleck in dem Abschnitt der Belichtungsbahn 110 zu aktivieren, welcher den zu belichtenden Teilbereich 100 voll überdeckt.

Um ein möglichst feines Schreibraster in der senkrecht zur Belichtungsbewegungsrichtung 104 verlaufenden Querrichtung 108 zu erhalten, ist bei einem dritten Ausführungsbeispiel der erfindungsgemäßen Lösung, wie in Fig. 11 dargestellt, die Serienrichtung 64 der Serie 62 in einem derart spitzen Winkel α relativ zur Belichtungsbewegungsrichtung 104 angeordnet, daß aufeinanderfolgende Lichtflecken 60₁, 60₂ oder 60₂, 60₃ usw. in der Querrichtung 108 um einen dem Inkrement d entsprechenden Bruchteil eines Durchmessers D der Lichtflecken 60 verschoben ist, so daß sich, wie im zweiten Ausführungsbeispiel gemäß Fig. 11 dargestellt, beispielsweise ein Schreibraster mit Inkrement d erreichen läßt, welche ein Zehntel des Durchmessers D der Lichtflecken 60 darstellt. Das heißt, daß der Lichtflecken 60₁₀ der Serie 62 gegenüber dem Lichtflecken 60₁ um die Breite 10 x d = D in der Querrichtung 108 verschoben ist.

Es sind aber auch gröbere Schreibraster denkbar, wobei die durch das Inkrement d bestimmte Schreibraster mindestens ein Viertel von D betragen sollte, um eine ausreichende Feinheit des Schreibrasters in der Querrichtung 108 senkrecht zur Belichtungsbewegungsrichtung 104 zu erhalten.

Vorzugsweise ist in diesem Fall das Lichtfleckmuster 70' durch eine Vielzahl von parallel zueinander verlaufenden Serien 62ₐ bis 62_{d} von Lichtflecken 60 gebildet, wobei innerhalb jeder Serie von Lichtfleck zu Lichtfleck ein vorgegebenes Inkrement d in der Querrichtung 108 besteht.

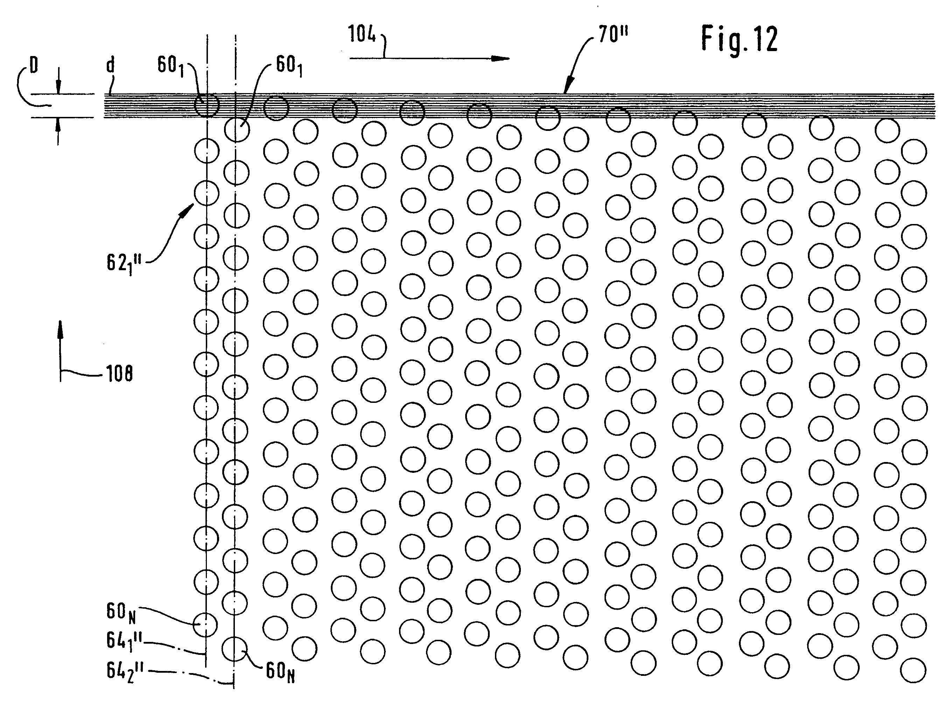

Bei einem dritten Ausführungsbeispiel eines erfindungsgemäßen Lichtfleckmusters 70", dargestellt in Fig. 12, erstrecken sich die Serienrichtungen 64 der einzelnen Serien 62" senkrecht zu Belichtungsbewegung 104, die Lichtflecken 60 der einzelnen Serien 62" sind jedoch so gegeneinander versetzt, daß im gesamten Lichtfleckmuster 70' zu jedem Lichtfleck 60 ein weiterer Lichtfleck existiert, welcher um ein Inkrement d in der Querrichtung 108 senkrecht zur Belichtungsbewegungsrichtung 104 versetzt ist.

Somit ist insgesamt mit einem derartigen Lichtfleckmuster 70" die Möglichkeit gegeben, Belichtungsbahnen 110 mit einer Auflösung d in der Querrichtung 108 nebeneinanderliegend zu erzeugen, und somit die für die Herstellung eines belichteten Teilbereichs 100 erforderlichen Streifenbereiche 100 überlappend zu generieren, wobei in einem Zug das gesamte Lichtfleckmuster 70" in der Belichtungsbewegungsrichtung 104 über die lichtempfindliche Schicht 34 des Substrats 36 hinwegfährt, und zwar vorzugsweise über das gesamte Substrat 36. Innerhalb der durch das Lichtfleckmußster 70" vorgegebenen "Breite" senkrecht zur Belichtungsbewegungsrichtung 104 ist dabei eine präzise Belichtung des Substrats 36 möglich, da die relative Anordnung der Lichtflecken zueinander und die Größe derselben unverändert bestehen bleiben.

Hernach ist - sofern sich das Lichtfleckmuster 70" nicht bereits in der Querrichtung 108 über das gesamte Substrat 36 erstreckt - das Lichtfleckmuster 70" als Ganzes in der Querrichtung 108 um eine Distanz zu versetzen, welche der Ausdehnung des Lichtfleckmusters 70" in der Querrichtung 108 entspricht, wobei bei jedem Überfahren der lichtempfindlichen Schicht 34 eine Belichtung über die gesamte Erstreckung des Lichtfleckmusters 70" in der Querrichtung 108 möglich ist, so daß zum Belichten der gesamten lichtempfindlichen Schicht 34 auf dem Substrat 36 wenige Belichtungsbewegungen des Lichtfleckmusters 70" in der Belichtungsbewegungsrichtung 104 erforderlich sind, deren Zahl sich aus der Erstreckung der lichtempfindlichen Schicht 34 in der Querrichtung 108 dividiert durch die Erstreckung des Lichtfleckmusters 70" in dieser Richtung ergibt.

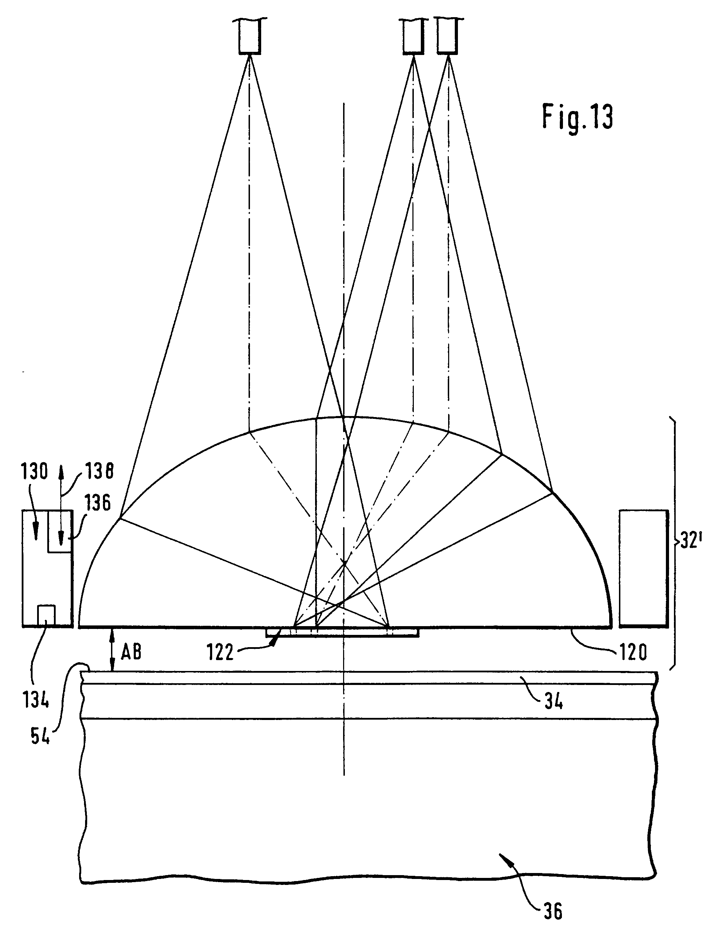

Bei einem Ausführungsbeispiel der erfindungsgemäßen Lösung, dargestellt in Fig. 13, ist die Lithographie-Belichtungseinrichtung in gleicher Weise aufgebaut, wie bei den vorangehenden Ausführungsbeispielen, insbesondere dem Ausführungsbeispiel gemäß Fig. 4, mit dem Unterschied, daß die Mikroskopoptik 32' auf ihrer der lichtempfindlichen Schicht 34 zugewandten Seite 120 mit einer Nahfeldoptik 122 versehen ist, welche in dem Bereich angeordnet ist, in welchem die durch die Mikroskopoptik 32' verkleinert abgebildete Laserstrahlung aus dieser austritt. Die Nahfeldoptik 122 kann dabei in unterschiedlichster Art und Weise ausgebildet sein.

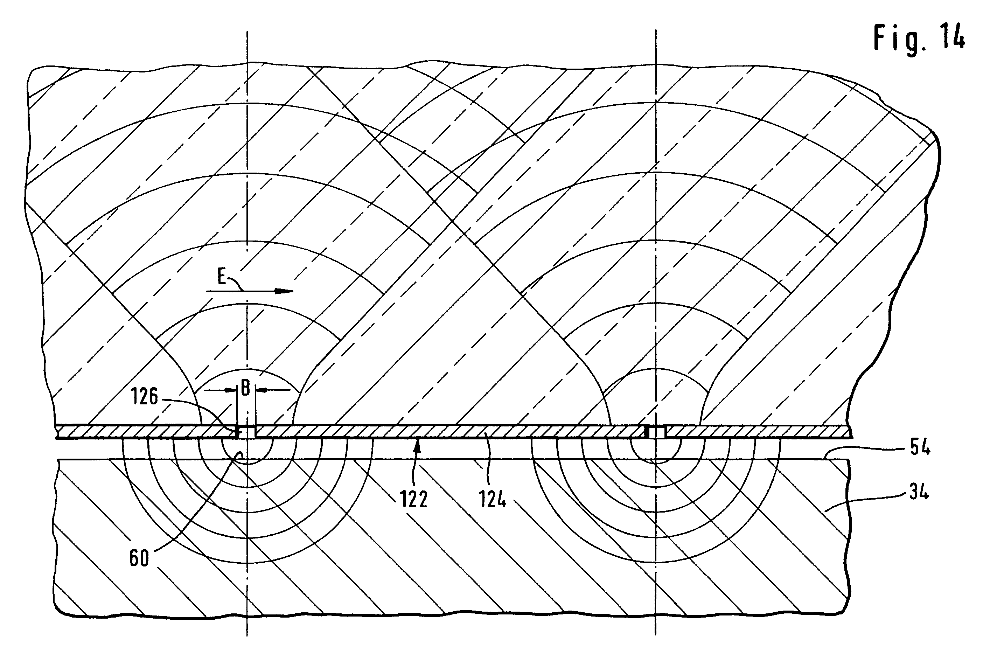

Wie in Fig. 14 dargestellt, wird die Nahfeldoptik durch eine Beschichtung 124 gebildet, welche reflektierend oder absorbierend ausgebildet ist und blendenähnliche Öffnungen 126 aufweist, durch welche dann die Laserstrahlung austritt. Mit den blendenähnlichen Öffnungen 126 ist dabei unabhängig von der Strahlformung durch die übrige Mikroskopoptik 32' die Größe der Lichtflecken 60 festlegbar. Beispielsweise können die blendenähnlichen Öffnungen 126 so dimensioniert werden, daß die Lichtflecken 60 in zumindest einer Richtung eine Ausdehnung aufweisen, die in der Größe der verwendeten Wellenlänge des Laserlichts oder kleiner ist. Somit sind beispielsweise Ausdehnungen der Lichtflecken in der Größenordnung von mehreren 100 beispielsweise, aber auch 100 oder 200 Nannometer, zumindest in einer Richtung erreichbar, wobei in diesem Fall die eintretende Lichtwelle einen Vektor des elektrischen Feldes E aufweisen muß, welcher parallel zur Breite B verläuft, die eine derartige Dimension aufweist.

Senkrecht zur Breite B haben die blendenähnlichen Öffnungen 126 dann vorzugsweise eine Dimension aufzuweisen, die mindestens in der Größenordnung der Wellenlänge liegt und mindestens der Ausdehnung des B-Feldes der Lichtwelle entspricht.

Die aus der blendenähnlichen Öffnung 126 austretende Laserstrahlung ist aufgrund der Größe der blendenähnlichen Öffnung 126 nicht mehr mit den Gesetzen der geometrischen Optik beschreibbar, sondern eher mit einer Kugelwelle, wie in Fig. 14 dargestellt, wobei in diesem Fall die Kugelwelle die Dimension des Lichtflecks 60 auf der Oberfläche 54 der lichtempfindlichen Schicht 34 bestimmt.

Aus diesem Grund ist es erforderlich, die Mikroskopoptik 32' mit einer Höhenverstelleinrichtung 130 zu versehen, welche die Nahfeldoptik 122 in einem definierten Abstand AB über der Oberfläche 54 der lichtempfindlichen Schicht 34 während der Belichtungsbewegungen in der Belichtungsbewegungsrichtung 134 führt. Die Höhenverstelleinrichtung 130 hält dabei vorzugsweise die Nahfeldoptik 122 und somit die gesamte Mikroskopoptik 32' in einem Abstand AB über der Oberfläche 54 der lichtempfindlichen Schicht 34, welcher ungefähr der Größe des Lichtflecks 60 entspricht, also somit ungefähr in der Größenordnung der Wellenlänge des Laserlichts liegt. Damit ist sichergestellt, daß die Größe des Lichtflecks 60 nicht dadurch verändert wird, daß sich der Abstand AB zwischen der Oberfläche 54 und der Nahfeldoptik 122 während der Belichtungsbewegung in Belichtungsbewegungsrichtung wesentlich ändert.

Vorzugsweise arbeitet eine derartige Höhenverstelleinrichtung 130 mit einem Sensor 134, welcher stets den Abstand von der Oberfläche 54 erfaßt und einem Stellglied 136, welches vorzugsweise die gesamte Mikroskopoptik 32' in einer Höhenrichtung 138 senkrecht zur Oberfläche 54 verstellt.

Mit einer derartigen Höhenverstelleinrichtung 130 sind somit auch Variationen in der Dicke des Substrats 36 sowie der Dicke der lichtempfindlichen Schicht 34 ausgleichbar.

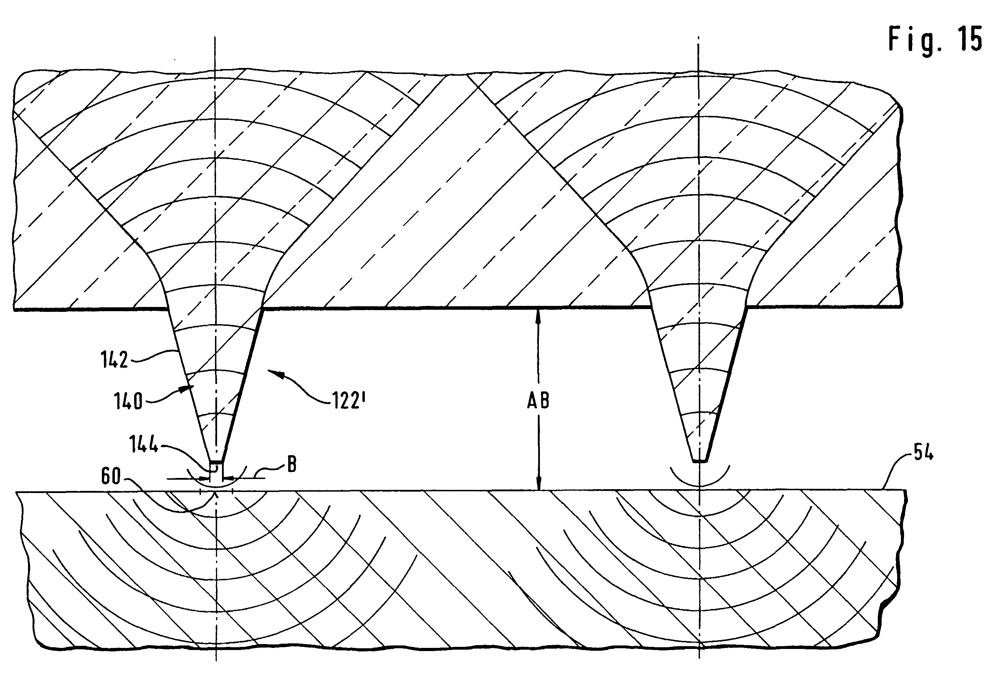

Bei einer in Fig. 15 dargestellten Variante 122' der Nahfeldoptik 122 sind anstelle der blendenähnlichen Öffnungen 126 Konen 140 aus einem dem Material der Mikroskopoptik 32' entsprechenden Material angeformt, wobei eine Mantelfläche 142 der Konen 140 zu einer Totalreflektion der Lichtwelle führt, die im Bereich einer abgeflachten Konusspitze 144 dann austritt. Die abgeflachte Konusspitze 144 kann dabei eine Breite B aufweisen, welche in der Größenordnung der Wellenlänge liegt oder kleiner als dieselbe ist, so daß die dann aus der Fläche 144 austretende Lichtwelle ebenfalls als Kugelwelle zu beschreiben ist und einen Lichtfleck 60 ergibt, welcher zumindest in Richtung der Breite B eine Ausdehnung in der Größenordnung der Lichtwelle, beispielsweise im Bereich von 100 oder 200 Nanometer, aufweist.

Auch bei diesem Ausführungsbeispiel ist es erforderlich, die Mikroskopoptik 32' in definiertem Abstand AB über der Oberfläche 54 zu führen, so daß auch bei diesem Ausführungsbeispiel die Höhenverstelleinrichtung 130 erforderlich ist, um Schwankungen in der Größe der Lichtflecken 60 zu verhindern.

## Patentansprüche

1. Lithographie-Belichtungseinrichtung umfassend eine Aufnahme für ein mit einer lichtempfindlichen Schicht versehenes Substrat, eine Belichtungseinheit welche eine Vielzahl von Halbleiterlasern(10₁ bis 10_{N}) und eine Strahlführungsoptik (16) umfaßt, die die Laserstrahlung jedes Halbleiterlasers (10₁ bis 10_{N}) zu einem Lichtfleck (60₁ bis 60_{N}) eines definierten Lichtfleckmusters (70) führt, mit welchem die lichtempfindliche Schicht des in der Aufnahme gehaltenen Substrats belichtbar ist, eine Bewegungseinheit zur Erzeugung einer Relativbewegung zwischen der Strahlführungsoptik der Belichtungseinheit und der Aufnahme, so daß das gesamte Lichtfleckmuster (70) und die Aufnahme (38) in einer Belichtungsbewegungsrichtung (104) relativ zueinander bewegbar sind und eine Steuerung zur Intensitäts- und Lagesteuerung der Lichtflecken auf der lichtempfindlichen Schicht des Substrats, mit welcher die Lichtflecken (60₁ bis 60_{N}) des Lichtfleckmusters (70) entsprechend der Form der zu belichtenden Teilbereiche (100) aktivierbar oder deaktivierbar sind, wobei das Lichtfleckmuster (70) von einem als Referenz dienenden Lichtfleck (60₁) ausgehend in einer senkrecht zur Belichtungsbewegungsrichtung (104) verlaufenden Querrichtung (108) in unterschiedlichen Abständen angeordnete Lichtflecken (60₁ bis 60_{N}) aufweist und jeder Lichtfleck (60₁ bis 60_{N}) des Lichtfleckmusters (70) in der Querrichtung (108) einen anderen Abstand (AQ) von dem als Referenz dienenden Lichtfleck (60₁) aufweist als die übrigen Lichtflecken (60₂ bis 60_{N}),
**dadurch gekennzeichnet, daß** die Abstände (AQ) aller Lichtflecken (60₁ bis 60_{N}) des Lichtfleckmusters eine Serie von Abständen bilden, bei der jeder Abstand (AQ) um ein Inkrement (d) größer als ein anderer der Abstände ist, und daß das Inkrement (d) kleiner als eine Erstreckung (D) der Lichtflecken (60₁ bis 60_{N}) in der Querrichtung (108) ist.

2. Lithographie-Belichtungseinrichtung nach Anspruch 1, **dadurch gekennzeichnet, daß** das Inkrement (d) maximal die Hälfte der Erstreckung (D) der Lichtflecken (60) in der Querrichtung (108) beträgt.

3. Lithographie-Belichtungseinrichtung nach einem der voranstehenden Ansprüche, **dadurch gekennzeichnet, daß** das Lichtfleckmuster (70) mindestens eine in einer Reihe angeordnete Serie (62) von Lichtflecken (60₁ bis 60_{N}) umfaßt, die senkrecht zur Belichtungsbewegungsrichtung (104) einen Abstand voneinander aufweisen, welcher kleiner als deren Ausdehnung (D) senkrecht zur Belichtungsbewegungsrichtung (104) ist.

4. Lithographie-Belichtungseinrichtung nach Anspruch 3, **dadurch gekennzeichnet, daß** der Abstand zwischen den Lichtflecken (60₁ bis 60_{N}) der Serie (62) senkrecht zur Bewegungsrichtung (104) konstant ist.

5. Lithographie-Belichtungseinrichtung nach Anspruch 3 oder 4 **dadurch gekennzeichnet, daß** in der Serie (62) die Lichtflecken (60₁ bis 60_{N}) in einer längs einer Geraden (64) verlaufenden Reihe angeordnet sind.

6. Lithographie-Belichtungseinrichtung nach Anspruch 5, **dadurch gekennzeichnet, daß** in der jeweiligen Reihe die Lichtflecken (60₁ bis 60_{N}) in Serienrichtung (64) einen Abstand (A) voneinander aufweisen, welcher größer ist als deren Erstreckung (D) in der Serienrichtung (64).

7. Lithographie-Belichtungseinrichtung nach Anspruch 6, **dadurch gekennzeichnet, daß** die Serienrichtung (64) einen Winkel (α) von ungleich 90° mit der Belichtungsbewegungsrichtung (104) einschließt.

8. Lithographie-Belichtungseinrichtung nach einem der voranstehenden Ansprüche, **dadurch gekennzeichnet, daß** die Belichtungseinheit den Halbleiterlasern (90₁ bis 90_{N}) nachgeschaltete Frequenzverdoppler (96₁ bis 96_{N}) umfaßt.

9. Lithographie-Belichtungseinrichtung nach einem der voranstehenden Ansprüche, **dadurch gekennzeichnet, daß** die Belichtungseinheit die Laserstrahlung zur Strahlführungsoptik (16) leitende Lichtleiter (14₁ bis 14_{N}) umfaßt.

10. Lithographie-Belichtungseinrichtung nach Anspruch 9, **dadurch gekennzeichnet, daß** die Lichtleiter (14₁ bis 14_{N}) ein erstes Ende (12₁ bis 12_{N}) aufweisen, in welches die Laserstrahlung einkoppelbar ist und ein zweites Ende (18₁ bis 18_{N}), aus welchem die Laserstrahlung austritt, und daß auf jedes zweite Ende (18₁ bis 18_{N}) folgend ein kollimierendes Element (22₁ bis 22_{N}) angeordnet ist, welches die divergent aus jedem einzelnen zweiten Ende (18₁ bis 18_{N}) der Lichtleiter (14₁ bis 14_{N}) austretende Laserstrahlung kollimiert und daraus ein kollimiertes Strahlungsbündel formt.

11. Lithographie-Belichtungseinrichtung nach einem der voranstehenden Ansprüche, **dadurch gekennzeichnet, daß** die Strahlführungsoptik (16) ein verkleinernd abbildendes Teleskop (26) umfaßt.

12. Lithographie-Belichtungseinrichtung nach einem der voranstehenden Ansprüche, **dadurch gekennzeichnet, daß** die Strahlführungsoptik (16) eine die Lichtflecke erzeugende Mikroskopoptik (32) umfaßt.

13. Lithographie-Belichtungseinrichtung nach Anspruch 12 **dadurch gekennzeichnet, daß** die Mikroskopoptik (32, 32') an einer Höhenpositioniereinrichtung (130) angeordnet ist und von dieser während der Belichtungsbewegung in einem definierten Abstand (AB) über der lichtempfindlichen Schicht positionierbar ist.

14. Lithographie-Belichtungseinrichtung nach Anspruch 13, **dadurch gekennzeichnet, daß** ein vorgegebener Abstand (AB) zwischen einer der lichtempfindlichen Schicht (34) zugewandten Unterseite (120) der Mikroskopoptik (32, 32') und der lichtempfindlichen Schicht durch die Höhenpositioniereinrichtung (130) einhaltbar ist.

15. Lithographie-Belichtungseinrichtung nach Anspruch 13 oder 14, **dadurch gekennzeichnet, daß** der Abstand (AB) in der Größenordnung eines Durchmessers des einzelnen Lichtflecks (60) auf der lichtempfindlichen Schicht liegt.

16. Lithographie-Belichtungseinrichtung nach einem der Ansprüche 12 bis 14, **dadurch gekennzeichnet, daß** die Mikroskopoptik (32') mit einer die Größe der Lichtflecke auf der lichtempfindlichen Schicht (34) definierenden Nahfeldoptik (122, 122') versehen ist.

17. Lithographie-Belichtungseinrichtung nach Anspruch 16, **dadurch gekennzeichnet, daß** die Nahfeldoptik (122, 122') unmittelbar auf einer der lichtempfindlichen Schicht (34) zugewandten Unterseite (120) der Mikroskopoptik (32') angeordnet ist.

18. Lithographie-Belichtungseinrichtung nach Anspruch 16 oder 17, **dadurch gekennzeichnet, daß** die Nahfeldoptik (122) die Lichtflecken (60) des Lichtfleckenmusters (70) durch blendenähnliche Durchlaßbereiche (126) definiert.

19. Lithographie-Belichtungseinrichtung nach Anspruch 16 oder 17, **dadurch gekennzeichnet, daß** die Nahfeldoptik (122') die Größe der Lichtflecken (60) des Lichtfleckmusters (70) durch strahlkonzentrierende Elemente (140) definiert.

20. Lithographie-Belichtungseinrichtung nach einem der Ansprüche 16 bis 19, **dadurch gekennzeichnet, daß** die Nahfeldoptik (122, 122') die Größe der Lichtflecken (60) in zumindest einer Richtung (B) auf Werte kleiner als die Wellenlänge der Laserstrahlung reduziert.

21. Lithographie-Belichtungseinrichtung nach einem der voranstehenden Ansprüche, **dadurch gekennzeichnet, daß** diese mehrere Lichtfleckmuster (70) erzeugt.

## Claims

1. Lithography exposure device comprising a mounting device for a substrate provided with a light-sensitive layer, an exposure unit comprising a plurality of semiconductor lasers (10₁ to 10_{N}) and an optical beam guidance means (16) which guides the laser radiation of each semiconductor laser (10₁ to 10_{N}) to a light spot (60₁ to 60_{N}) of a defined light spot pattern (70), by means of which the light-sensitive layer of the substrate held in the mounting device is exposable, a movement unit for generating a relative movement between the optical beam guidance means of the exposure unit and the mounting device, so that the entire light spot pattern (70) and the mounting device (38) are movable relative to one another in an exposure movement direction (104), and a control for controlling the intensity and position of the light spots on the light-sensitive layer of the substrate, by means of which the light spots (60₁ to 60_{N}) of the light spot pattern (70) are activatable or deactivatable in accordance with the shape of the sections (100) to be exposed, the light spot pattern (70) having light spots (60₁ to 60_{N}) arranged at different distances in a transverse direction (108) extending at right angles to the exposure movement direction (104) proceeding from a light spot (60₁) serving as reference, and each light spot (60₁ to 60_{N}) of the light spot pattern (70) having in the transverse direction (108) a different distance (AQ) from the light spot (60₁) serving as reference than the remaining light spots (60₂ to 60_{N}), **characterized in that** the distances (AQ) of all the light spots (60₁ to 60_{N}) of the light spot pattern form a series of distances, in which each distance (AQ) is greater by one increment (d) than another one of the distances, and **in that** the increment (d) is smaller than an extension (D) of the light spots (60₁ to 60_{N}) in the transverse direction (108).

2. Lithography exposure device as defined in claim 1, **characterized in that** the increment (d) is at the most half the extension (D) of the light spots (60) in the transverse direction (108).

3. Lithography exposure device as defined in any one of the preceding claims, **characterized in that** the light spot pattern (70) comprises at least one series (62) of light spots (60₁ to 60_{N}) arranged in a row, the light spots having at right angles to the exposure movement direction (104) a distance from one another which is smaller than their extension (D) at right angles to the exposure movement direction (104).

4. Lithography exposure device as defined in claim 3, **characterized in that** the distance between the light spots (60₁ to 60_{N}) of the series (62) is constant at right angles to the direction of movement (104).

5. Lithography exposure device as defined in claim 3 or 4, **characterized in that** in the series (62) the light spots (60₁ to 60_{N}) are arranged in a row extending along a straight line (64).

6. Lithography exposure device as defined in claim 5, **characterized in that** in the respective row the light spots (60₁ to 60_{N}) have in series direction (64) a distance (A) from one another which is greater than their extension (D) in the series direction (64).

7. Lithography exposure device as defined in claim 6, **characterized in that** the series direction (64) forms an angle (α) not equal to 90° with the exposure movement direction (104).

8. Lithography exposure device as defined in any one of the preceding claims, **characterized in that** the exposure unit comprises frequency doublers (96₁ to 96_{N}) which follow the semiconductor lasers (90₁ to 90_{N}).

9. Lithography exposure device as defined in any one of the preceding claims, **characterized in that** the exposure unit comprises light guides (14₁ to 14_{N}) which guide the laser radiation to the optical beam guidance means (16).

10. Lithography exposure device as defined in claim 9, **characterized in that** the light guides (14₁ to 14_{N}) have a first end (12₁ to 12_{N}) into which the laser radiation can be coupled, and a second end (18₁ to 18_{N}) from which the laser radiation exits, and **in that** a collimating element (22₁ to 22_{N}) is arranged so as to follow each second end (18₁ to 18_{N}), said element collimating the laser radiation exiting divergently from each individual second end (18₁ to 18_{N}) of the light guides (14₁ to 14_{N}) and forming therefrom a collimated radiation bundle.

11. Lithography exposure device as defined in any one of the preceding claims, **characterized in that** the optical beam guidance means (16) comprises a telescope (26) for reduced imaging.

12. Lithography exposure device as defined in any one of the preceding claims, **characterized in that** the optical beam guidance means (16) comprises an optical microscope (32) for generating the light spots.

13. Lithography exposure device as defined in claim 12, **characterized in that** the optical microscope (32, 32') is arranged on a height positioning device (130) and is positionable by the latter during the exposure movement at a defined distance (AB) above the light-sensitive layer.

14. Lithography exposure device as defined in claim 13, **characterized in that** a predetermined distance (AB) between an underside (120) of the optical microscope (32, 32') facing the light-sensitive layer (34) and the light-sensitive layer is able to be maintained by the height positioning device (130).

15. Lithography exposure device as defined in claim 13 or 14, **characterized in that** the distance (AB) is in the order of magnitude of a diameter of the individual light spot (60) on the light-sensitive layer.

16. Lithography exposure device as defined in any one of claims 12 to 14, **characterized in that** the optical microscope (32') is provided with a near-field optical means (122, 122') defining the size of the light spots on the light-sensitive layer (34).

17. Lithography exposure device as defined in claim 16, **characterized in that** the near-field optical means (122, 122') is arranged directly on an underside (120) of the optical microscope (32') facing the light-sensitive layer (34).

18. Lithography exposure device as defined in claim 16 or 17, **characterized in that** the near-field optical means (122) defines the light spots (60) of the light spot pattern (70) by way of aperture-like through-regions (126).

19. Lithography exposure device as defined in claim 16 or 17, **characterized in that** the near-field optical means (122') defines the size of the light spots (60) of the light spot pattern (70) by way of beam-concentrating elements (140).

20. Lithography exposure device as defined in any one of claims 16 to 19, **characterized in that** the near-field optical means (122, 122') reduces the size of the light spots (60) in at least one direction (B) to values smaller than the wavelength of the laser radiation.

21. Lithography exposure device as defined in any one of the preceding claims, **characterized in that** this generates several light spot patterns (70).

## Revendications

1. Dispositif d'exposition pour lithographie comprenant un logement pour un substrat muni d'une couche sensible à la lumière, une unité d'exposition qui comprend une pluralité de lasers semi-conducteurs (10₁ à 10_{N}) et une optique de guidage de rayon (16), laquelle mène le rayonnement laser de chaque laser semi-conducteur (10₁ à 10_{N}) à un spot lumineux (60₁ à 60_{N}) d'un échantillon de spot lumineux défini (70), avec lequel la couche sensible à la lumière du substrat maintenu dans le logement peut être exposée, une unité de déplacement pour la production d'un mouvement relatif entre l'optique de guidage de rayon de l'unité d'exposition et le logement, de sorte que l'ensemble échantillon de spot lumineux (70) et le logement (38) peuvent être déplacés l'un par rapport à l'autre dans un mouvement de déplacement d'exposition (104) et une commande pour la commande de position et d'intensité des spots lumineux sur la couche sensible à la lumière du substrat avec laquelle les spots lumineux (60₁ à 60_{N}) de l'échantillon de spot lumineux (70) peuvent être activés ou désactivés en fonction de la forme des zones partielles (100) à exposer, l'échantillon de spot lumineux (70), en partant d'un spot lumineux (60₁) servant de référence dans une direction transversale (108) s'étendant perpendiculairement à la direction de déplacement d'exposition (104), présente des spots lumineux (60₁ à 60_{N}) disposés selon des espacements différents, et chaque spot lumineux (60₁ à 60_{N}) de l'échantillon de spot lumineux (70) présente dans la direction transversale (108) un autre espacement (AQ) par rapport au spot lumineux (60₁) servant de référence que les autres spots lumineux (60₂ à 60_{N}), **caractérisé en ce que** les espacements (AQ) de tous les spots lumineux (60₁ à 60_{N}) de l'échantillon de spot lumineux forment une série d'espacements, dans laquelle chaque espacement (AQ) est supérieur d'un incrément (d) par rapport à un autre des espacements et **en ce que** l'incrément (d) est plus petit qu'une extension (D) des spots lumineux (60₁ jusqu'à 60_{N}) dans la direction transversale (108).

2. Dispositif d'exposition pour lithographie selon la revendication 1, **caractérisé en ce que** l'incrément (d) est égal au maximum à la moitié de l'extension (D) des spots lumineux (60) dans la direction transversale (108).

3. Dispositif d'exposition pour lithographie selon l'une des revendications précédentes, **caractérisé en ce que** l'échantillon de spot lumineux (70) comprend au moins une série (62), disposée dans une rangée, de spots lumineux (60₁ à 60_{N}), qui présentent une distance entre eux, perpendiculairement à la direction de déplacement d'exposition (104), distance qui est inférieure à leur extension (D) perpendiculairement à la direction de déplacement d'exposition (104).

4. Dispositif d'exposition pour lithographie selon la revendication 3, **caractérisé en ce que** la distance entre les spots lumineux (60₁ à 60_{N}) de la série (62) perpendiculairement à la direction de déplacement (104) est constante.

5. Dispositif d'exposition pour lithographie selon la revendication 3 ou la revendication 4, **caractérisé en ce que**, dans la série (62), les spots lumineux (60₁ à 60_{N}) sont disposés dans une rangée s'étendant le long d'une droite (64).

6. Dispositif d'exposition pour lithographie selon la revendication 5, **caractérisé en ce que**, dans la rangée respective, les spots lumineux (60₁ à 60_{N}) présentent dans la direction de la série (64) un espacement (A) entre eux, espacement qui est supérieur à leur extension (D) dans la direction de la série (64).

7. Dispositif d'exposition pour lithographie selon la revendication 6, **caractérisé en ce que** la direction de série (64) inclut un angle (α) supérieur à 90° par rapport à la direction de déplacement d'exposition (104).

8. Dispositif d'exposition pour lithographie selon l'une des revendications précédentes, **caractérisé en ce que** l'unité d'exposition comprend les doubleurs de fréquence (96₁ à 96_{N}) montés en amont des lasers semi-conducteurs (90₁ à 90_{N}).

9. Dispositif d'exposition pour lithographie selon l'une des revendications précédentes, **caractérisé en ce que** l'unité d'exposition comprend les guides de lumière (14₁ à 14_{N}) guidant le rayonnement laser à l'optique de guidage de rayon (16).

10. Dispositif d'exposition pour lithographie selon la revendication 9, **caractérisé en ce que** les guides de lumière (14₁ à 14_{N}) présentent une première extrémité (12₁ à 12_{N}) dans laquelle le rayonnement laser est injecté et une seconde extrémité (18₁ à 18_{N}) à partir de laquelle sort le rayonnement laser, et **en ce que** sur chaque seconde extrémité (18₁ à 18_{N}) est disposé en succession un élément de collimation (22₁ à 22_{N}) qui collimate le rayonnement laser sortant de façon divergente à partir de chaque seconde extrémité individuelle (18₁ jusqu'à 18_{N}) des guides de lumière (14₁ jusqu'à 14_{N}) et forme à partir de celui-ci un faisceau de rayonnements collimatés.

11. Dispositif d'exposition pour lithographie selon l'une des revendications précédentes, **caractérisé en ce que** l'optique de guidage de rayon (16) comprend un télescope (26) de représentation rapetissante.

12. Dispositif d'exposition pour lithographie selon l'une des revendications précédentes, **caractérisé en ce que** l'optique de guidage de rayon (16) comprend une optique de microscope (32) produisant les spots lumineux.

13. Dispositif d'exposition pour lithographie selon la revendication 12, **caractérisé en ce que** l'optique de microscope (32, 32') est disposée sur un système de positionnement en hauteur (130) et à partir de celui-ci, pendant le déplacement d'exposition, peut être positionnée dans un espacement défini (AB) sur la couche sensible à la lumière.

14. Dispositif d'exposition pour lithographie selon la revendication 13, **caractérisé en ce qu'**un espacement prédéfini (AB) entre un côté inférieur (120) détourné de la couche sensible à la lumière (34) de l'optique de microscope (32, 32') et la couche sensible à la lumière pourra être maintenu par le système de positionnement en hauteur (130).

15. Dispositif d'exposition pour lithographie selon la revendication 13 ou 14, **caractérisé en ce que** l'espacement (AB) se situe dans l'ordre de grandeur d'un diamètre de spot lumineux individuel (60) sur la couche sensible à la lumière.

16. Dispositif d'exposition pour lithographie selon l'une des revendications 12 à 14, **caractérisé en ce que** l'optique de microscope (32') est munie d'une optique de champ proche (122, 122') définissant la grandeur des spots lumineux sur la couche sensible à la lumière (34).

17. Dispositif d'exposition pour lithographie selon la revendication 16, **caractérisé en ce que** l'optique de champ proche (122, 122') est disposée directement sur un côté inférieur (120) de l'optique de microscope (32'), côté inférieur détourné de la couche sensible à la lumière (34).

18. Dispositif d'exposition pour lithographie selon la revendication 16 ou 17, **caractérisé en ce que** l'optique de champ proche (122) définit les spots lumineux (60) de l'échantillon de spot lumineux (70) par des zones passantes (126) similaires à un diaphragme.

19. Dispositif d'exposition pour lithographie selon la revendication 16 ou 17, **caractérisé en ce que** l'optique de champ proche (122') définit la grandeur des spots lumineux (60) de l'échantillon de spot lumineux (70) par des éléments de concentration de rayon (140).

20. Dispositif d'exposition pour lithographie selon l'une des revendications 16 à 19, **caractérisé en ce que** l'optique de champ proche (122, 122') réduit la grandeur des spots lumineux (60) dans au moins une direction (B) à des valeurs inférieures à la longueur d'onde du rayonnement laser.

21. Dispositif d'exposition pour lithographie selon l'une des revendications précédentes, **caractérisé en ce que** celui-ci produit plusieurs échantillons de spots lumineux (70).
